# EUROPEAN PATENT APPLICATION

(11) **EP 1 480 506 A1**
(43) Date of publication of application: **24.11.2004**
(21) Application number: 03705259.4
(22) Date of filing: 18.02.2003
(51) Int. Cl.: H05K 13/02

(54) **PART FEEDING UNIT, PART FEEDING DEVICE, PART FEEDING METHOD, AND PART MOUNTING DEVICE**

(30) Priority: 19.02.2002 JP 2002041067
(71) Applicant: MATSUSHITA ELECTRIC INDUSTRIAL CO., LTD., Kadoma-shi, Osaka 571-8501 (JP)
(72) Inventor: SUMIDA, Hiroto, Ikoma-shi, Nara 630-0243 (JP); KITANI, Minoru, Takatsuki-shi, Osaka 569-0056 (JP)
(74) Representative: Eisenführ, Speiser & Partner
(86) International application number: PCT/JP2003/001688
(87) International publication number: WO 2003/071847

(57) **Abstract**

By a component feed method for conveying a belt-shaped component-feeding member (1), in which component storage sections (3) that store a plurality of electronic components (4) while allowing the components to be picked up and feed perforations (2) are formed at regular intervals (P) in their lengthwise direction, in its rotational direction by the rotation around the center of rotation (R) of a feed rotor (6) on the outer periphery of which a plurality of feed claws (5) capable of being engaged with the feed perforations and positioning each of the storage sections in a component pickup position (16) to feed the component from the positioned storage section, the rotational driving amount of the feed rotor is controlled on the basis of correctional driving amount data of the rotational driving of the feed rotor formed based on displacement amount data of each of the feed claws with respect to the center of rotation or the rotational direction of the feed rotor, and the components are positioned successively in the component pickup position to feed the components.

## Description

### Technical Field

The present invention relates to a component feed unit and component feed device and method and. a component mounting apparatus for mountably feeding a plurality of components by means of a belt-shaped component-feeding member in which a plurality of components are continuously stored at regular intervals during component mounting for mounting the plurality of components onto a board.

### Background Art

The conventional component feed device for use in the above kind of component mounting, or, for example, in mounting electronic components as the components has the following construction. That is, the construction includes a feed rotor that has feed claws to be engaged with feed perforations of the component-feeding member on its outer peripheral surface with a prescribed pitch to feed the belt-shaped component-feeding member in which component storage sections storing the electronic components and the feed perforations are provided in the lengthwise direction with the respective prescribed pitches and a ratchet mechanism section that is a rotary driving device for rotating this feed rotor. That is, the construction includes the feed claws provided with a prescribed pitch on the outer periphery of the feed rotor, and these feed claws are successively engaged with the feed perforations of the component-feeding member by rotationally driving the feed rotor, intermittently feeding the component-feeding member with a prescribed pitch.

Then, if the component storage section of the component-feeding member is positioned in a component pickup position in a prescribed position, then a suction nozzle of the component mounting apparatus equipped with the component feed device picks up the electronic component stored in the component storage section positioned in the component pickup position and mounts the electronic component onto a board.

However, according to the construction of the conventional component feed device, there are existing variation in the indexing accuracy of the feed claws of the feed rotor, i.e., variation in the formation pitch of the feed claws in the rotational direction of the feed rotor as well as variation in the center of rotation due to eccentricity or the like of the mounting portion of the feed rotor with respect to a rotational drive shaft and so on of the ratchet mechanism section, i.e., displacement between the center of rotation of the rotational drive shaft and the center of rotation of the feed rotor. If the component-feeding member is fed in the above-mentioned state, there occurs variation in the amount of feed during the intermittent feed, and there occurs displacement between the component storage section that should be located in the component pickup position and the component pickup position. This consequently leads to a problem that, in particular, minute electronic components cannot stably be picked up.

For explanation by a concrete example, if, for example, the indexing accuracy of each feed claw when the feed rotor is rotated by one turn is confirmed, then the accuracy becomes about ±20 µm. Although the above-mentioned accuracy can be improved by improving the processing quality of the feed rotor, it can be said that the accuracy is approximately at the utmost limit taking the realistic production cost of the component mounting apparatus into consideration.

Currently, in the field of electronic component mounting, there is a growing trend toward minimizing chip components as electronic components and narrowing the spacing of the mounting of the components on a board. In accordance with this, there is a growing demand for a higher accuracy with regard to the feeding accuracy of the component-feeding member of the component feed device. For example, in the case where a 0402-size chip component is picked up by being sucked and held from the component feed device by a suction nozzle, the chip component must be positioned within a range of not larger than about ±50 µm with respect to the suction nozzle.

With regard to the required accuracy as described above, the equipment side of the component mounting apparatus and the component feed device currently has (1) a head section positioning accuracy of about ±3 µm, (2) a mechanical variation of about ±20 µm at the tip of the suction nozzle and (3) positional variation of about ±10 µm ascribed to a mounting base for mounting the component feed device on the component mounting apparatus. According to the above, the positional accuracy required for the component feed device is not larger than ±17 µm (i.e., 50 µm - 3 µm - 20 µm - 10 µm = 17 µm). However, as described above, there is a problem that it is realistically difficult to produce a feed rotor which satisfies the above-mentioned accuracy.

Accordingly, the object of the present invention is to solve the aforementioned problems and provide a component feed unit, component feed device, component feed method and component mounting apparatus that is able to carry out high-accuracy stable feed in mountably feeding a plurality of components by means of a belt-shaped component-feeding member in which a plurality of components are continuously stored at regular intervals during component mounting for mounting the plurality of components onto a board and is particularly able to cope with the feeding of miniaturized components.

### Disclosure Of Invention

In accomplishing these and other aspect, according to a first aspect of the present invention, there is provided a component feed unit for positioning storage sections, which releasably store a plurality of electronic components in a belt-shaped component-feeding member in which the storage sections and feed perforations are formed at regular intervals in a lengthwise direction thereof, in a component pickup position and allowing the components to be fed from the positioned storage section, the unit comprising:
a feed rotor which has its outer periphery provided with a plurality of feed claws capable of being engaged with the feed perforations, for conveying the component-feeding member in its rotational direction by rotating around its center of rotation;
a rotary driving device for rotationally driving the feed rotor so that the component-feeding member is conveyed; and
a control section for controlling rotational driving amount of the feed rotor by the rotary driving device,
the control section retains correctional driving amount data of the rotational driving amount of the feed rotor formed based on displacement amount data of a formation position of the feed claws with respect to the rotational direction or the center of rotation of the feed rotor and controls the rotational driving amount of the feed rotor based on the correctional driving amount data so that the components are successively positioned in the component pickup position.

According to a second aspect of the present invention, there is provided a component feed unit as defined in the first aspect, wherein the displacement amount data are data formed based on an actual rotational movement position of each of the feed claws in the rotational direction of the feed rotor and a position where each of the feed claws should be positioned, when the feed rotor is rotationally driven by the rotary driving device so that each of the components is positioned in the component pickup position.

According to a third aspect of the present invention, there is provided a component feed unit as defined in the first aspect, wherein the control section comprises:
a correctional driving amount data formation section for forming the correctional driving amount data of the feed rotor by correcting the rotational driving amount data of each of the feed claws of the feed rotor by the rotary driving device capable of positioning each of the components in the component pickup position based on the displacement amount data; and
a data retainment section for retrievably retaining the displacement amount data, the rotational driving amount data and the correctional driving amount data.

According to a fourth aspect of the present invention, there is provided a component feed unit as defined in the first aspect, wherein the amount of displacement is an amount of displacement of the actual formation position with respect to a reference position of each of the feed claws that should be formed on the outer periphery of the feed rotor in correspondence with the regular formation intervals of the feed perforations of the component-feeding member.

According to a fifth aspect of the present invention, there is provided a component feed unit as defined in the first aspect, wherein the control section is operable to detect the rotational position of the feed rotor and controls the rotational driving amount of the feed rotor by the rotary driving device while carrying out the detection.

According to a sixth aspect of the present invention, there is provided a component feed unit as defined in the fifth aspect, wherein the detection of the rotational position of the feed rotor is carried out by an encoder for directly detecting the position in the rotational direction of the feed rotor.

According to a seventh aspect of the present invention, there is provided a component feed unit as defined in the fifth aspect, wherein the detection of the rotational position of the feed rotor is carried out by a detection device including an object to be detected provided for the feed rotor and a detection section for detecting a movement position of the object to be detected by the rotational driving of the feed rotor.

According to an eighth aspect of the present invention, there is provided a component feed unit as defined in the first aspect, wherein each of the feed claws has a cross section formed into a roughly circular shape perpendicularly to a radial direction of the feed rotor, and the component-feeding member is conveyed while making the roughly circular peripheral surfaces abut against inner peripheral surfaces of the feed perforations formed in a roughly circular shape at the component-feeding member.

According to a ninth aspect of the present invention, there is provided a component feed unit as defined in the first aspect, wherein the rotary driving device has a rotary driving motor which is connected directly to the feed rotor for directly rotationally driving the feed rotor.

According to a tenth aspect of the present invention, there is provided a component feed unit as defined in the first aspect, wherein the feed rotor has a rotational reference position in its rotational direction, and the control section is operable to correct the rotational reference position in the rotational direction based on the correctional driving amount data.

According to an eleventh aspect of the present invention, there is provided a component feed device comprising:
a unit retainment section removably equipped with the component feed unit defined in any one of aspects the first through the tenth;
a reel retainment portion which is provided for the unit retainment section for rotatably removably retaining a component feed reel around which the component-feeding member is wound and stored; and
a conveyance passage for conveying the component-feeding member fed by being unwinded from the component feed reel retained by the reel retainment portion feedably to the component feed unit.

According to a twelfth aspect of the present invention, there is provided a feed claw displacement amount measurement device comprising:
a retainment base which releasably retains the component feed unit defined in any one of aspects the first through the tenth;
an imaging device which is fixed to the retainment base for capturing an image of the formation position of each of the feed claws with respect to the center of rotation or the rotational direction of the feed rotor in the retained component feed device;
a displacement amount data formation section for forming displacement amount data of the formation position of each of the feed claws based on each of the images captured by the imaging device; and
a data output section for outputting the formed displacement amount data to the control section of the component feed device.

According to a thirteenth aspect of the present invention, there is provided a component mounting apparatus comprising:
a component feed section removably provided with a plurality of the component feed units defined in any one of aspects the first through the tenth arrayed in a line so that the respective component pickup positions are arrayed in a line;
a head section which is provided with a plurality of component holding members for releasably holding the components and are arrayed in a line along a direction in which the component pickup positions are arranged, holds the components fed from one or the plurality of component pickup positions among the plurality of component pickup positions by means of the component holding members and mounts the held one or the plurality of components in mounting position or positions of a board;
a board holding section which releasably holds the board; and
a positioning device for carrying out positioning of the held board and the component holding members,
the control section of each of the component feed units corrects the amount of displacement between the component pickup positions based on the displacement amount data, and allows the components to be picked up from the plurality of component pickup positions by the plurality of component holding members.

According to a fourteenth aspect of the present invention, there is provided a component feed method for conveying a belt-shaped component-feeding member, in which component storage sections that store a plurality of electronic components while allowing the components to be picked up and feed perforations are formed at regular intervals in a lengthwise direction thereof, in its rotational direction by the rotation around a center of rotation of a feed rotor on an outer periphery of which a plurality of feed claws capable of being engaged with the feed perforations and positioning each of the storage sections in a component pickup position to feed the component from the positioned storage section, whereby
the rotational driving amount of the feed rotor is controlled based on correctional driving amount data of the rotational driving of the feed rotor formed based on displacement amount data of each of the feed claws with respect to the center of rotation or the rotational direction of the feed rotor, and the components are positioned successively in the component pickup position to feed the components.

According to a fifteenth aspect of the present invention, there is provided a component feed method as defined in the fourteenth aspect, wherein the control of the rotational driving amount of the feed rotor is carried out so that an actual rotational driving amount calculated based on the position in the detected rotational direction coincides with a rotational driving amount based on the correctional driving amount data while directly detecting the position in the rotational direction of the feed rotor.

According to a sixteenth aspect of the present invention, there is provided a component feed method as defined in the fourteenth aspect, wherein the displacement amount data of the formation position of each of the feed claws is formed by capturing an image of a rotational movement position of each of the feed claws in the rotational direction when the feed rotor is rotationally driven so that each of the components is positioned in the component pickup position and being based on the rotational movement position of each of the feed claws detected based on each of the image and the position where each of the feed claws should be positioned.

According to a seventeenth aspect of the present invention, there is provided a component feed method as defined in the fourteenth aspect, wherein the displacement amount data are data of the amount of displacement of the rotational angle of each of the feed claws.

According to an eighteenth aspect of the present invention, there is provided a component feed method as defined in the fourteenth aspect, wherein the rotational driving amount data of each of the feed claws of the feed rotor that conveys the component-feeding member so that each of the components is positioned in the component pickup position is corrected based on the displacement amount data, whereby the correctional driving amount data of the feed rotor is formed and the rotational driving amount of the feed rotor is controlled by the formed correctional driving amount data.

According to a nineteenth aspect of the present invention, there is provided a component feed method as defined in the fourteenth aspect, wherein capturing an image of the component positioned in the component pickup position by a board recognition device provided for a component mounting apparatus that mounts the component fed to the component pickup position onto the board,
calculating an amount of displacement between the positioned component and the component pickup position based on the captured image, and
forming correctional driving amount data of the rotational driving amount of the feed rotor based on the calculated amount of displacement.

According to a twentieth aspect of the present invention, there is provided a component feed method as defined in the nineteenth aspect, wherein the amount of displacement between the positioned component and the component pickup position is a distance dimension in a direction in which the component-feeding member is conveyed, and the correctional driving amount data of the rotational driving amount of the feed rotor, which is a rotational angle, is formed based on the distance dimension and a diameter of the feed rotor.

### Brief Description Of Drawings

These and other aspects and features of the present invention will become clear from the following description taken in conjunction with the preferred embodiments thereof with reference to the accompanying drawings, in which:
Fig. 1 is a perspective view showing a component feed unit according to a first embodiment of the present invention;
Fig. 2 is a schematic perspective view' showing a feed rotor and its driving device in the above component feed unit;
Fig. 3 is a perspective view of the feed rotor of the above component feed unit;
Fig. 4 is a perspective view of a conventional feed rotor;
Fig. 5 is a plan view showing a state in which the component-feeding member is conveyed by the conventional feed rotor;
Fig. 6 is a plan view showing a state in which the component-feeding member is conveyed by the feed rotor of the first embodiment;
Fig. 7A is a side view showing the above feed rotor in a state in which variation occurs due to indexing accuracy; Fig. 7B is a partially enlarged view of a feed claw of the feed. rotor of Fig. 7A;
Fig. 8A is a side view showing the feed rotor in a state in which displacement occurs at the center of rotation; Fig. 8B is a partially enlarged view of the feed claw of the feed rotor of Fig. 8A;
Fig. 9A is a side view showing the feed rotor in a state in which neither variation nor displacement occurs; Fig. 9B is a partially enlarged view of the feed claw of the feed rotor of Fig. 9A;
Fig. 10 is a side view showing a state in which the component-feeding member is conveyed by the feed rotor of Fig. 9A;
Fig. 11 is a side view showing a state in which the component-feeding member is conveyed by the feed rotor in a state in which the variation and displacement of Fig. 7A or Fig. 8A occur;
Fig. 12 is a side view of the feed rotor of the first embodiment;
Fig. 13 is a schematic explanatory view showing the construction of a device for measuring the amount of displacement of the feed claws of the feed rotor;
Fig. 14 is a block diagram of the control device of the component feed unit;
Fig. 15 is a flow chart showing a procedure for forming data of the amount of displacement of the feed claws;
Fig. 16 is a flow chart showing a procedure for forming correctional driving amount data on the basis of the data of the amount of displacement;
Fig. 17 is a schematic explanatory view for explaining correction operation of the amount of displacement;
Fig. 18 is a perspective view of a feed claw displacement amount measurement device for measuring the amount of displacement;
Fig. 19 is a partially enlarged side view of the feed claw in a state in which no displacement occurs;
Fig. 20 is a partially enlarged side view of the feed claw in a state in which displacement occurs;
Fig. 21 is a partially enlarged plan view of a component pickup position of the component-feeding member in the state in which no displacement occurs;
Fig. 22 is a partially enlarged plan view of the component pickup position of the component-feeding member in the state in which displacement occurs;
Fig. 23 is a perspective view of an electronic component mounting apparatus according to a second embodiment of the present invention;
Fig. 24 is a partially enlarged perspective view of a component feed section in the above electronic component mounting apparatus;
Fig. 25 is a plan view showing a state in which displacement occurs in component pickup positions in the component feed unit arrayed in a line;
Fig. 26 is a plan view showing a state in which the displacement of Fig. 25 is corrected;
Fig. 27 is a perspective view of a head section and a component feed unit according to a modification example of the second embodiment; and
Fig. 28 is a perspective view of a component feed cassette equipped with the component feed unit.

### Best Mode for Carrying Out the Invention

Before the description of the present invention proceeds, it is to be noted that like parts are designated by like reference numerals throughout the accompanying drawings.

### (First Embodiment)

The first embodiment of the present invention will be described in detail below with reference to the drawings.

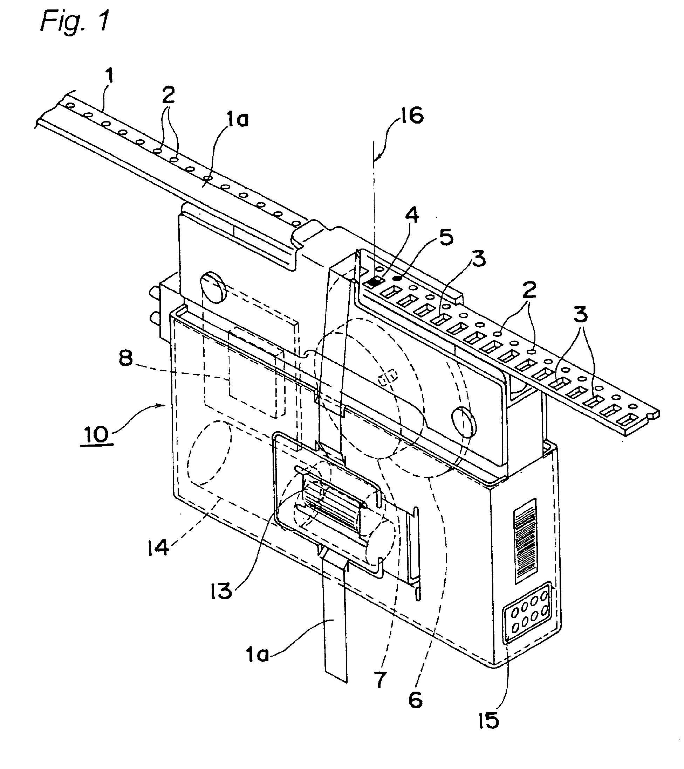

Fig. 1 shows a perspective view of a component feed unit 10 of one example of the component feed unit according to the first embodiment of the present invention. As shown in Fig. 1, this is the unit provided with the main devices that bear the conveyance of a component-feeding member in the component feed device and a control device therefor and is able to be removably mounted on the component feed device as described later.

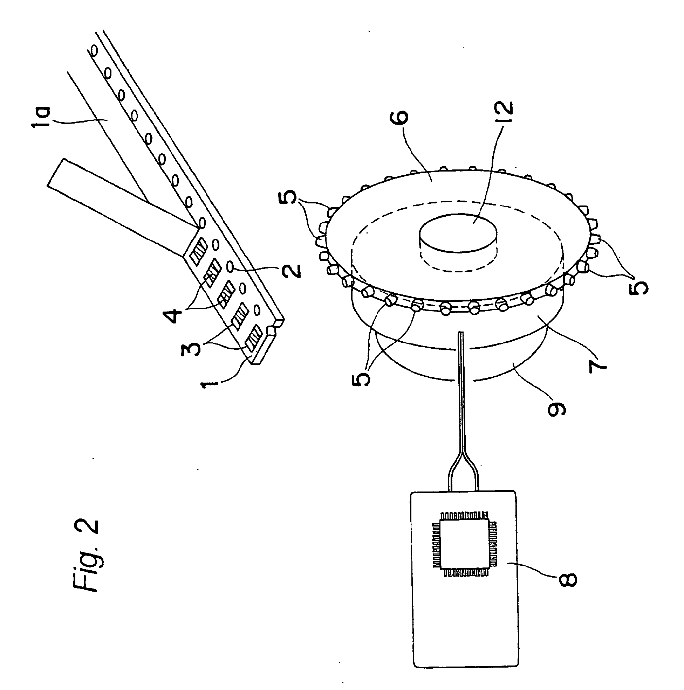

As shown in Fig. 1, the component feed unit 10 includes a feed rotor 6 for conveying a belt-shaped component-feeding member 1 arranged in its upper portion in the illustrated rightward direction, a motor 7 of one example of the rotational driving unit for rotationally driving the feed rotor 6 and a control device 8 of one example of the control section for controlling the rotational driving amount of the feed rotor 6 by the driving of the motor 7, i.e., controlling the feeding amount of the component-feeding member 1. Only the principal construction of the component feed unit 10 in the above-mentioned construction is schematically shown in Fig. 2.

As shown in Fig. 2, at the feed rotor 6 of the component feed unit 10, a plurality of feed claws 5, which are to be engage with feed perforations 2 of the belt-shaped component-feeding member 1 where component storage sections 3 of one example of the storage section that stores a plurality of electronic components 4 of one example of the components while allowing the components to be picked up and the feed perforations 2 are formed continuously at regular intervals (pitch) in the lengthwise direction, are formed at regular intervals (pitch) on the outer periphery of the feed rotor. It is preferred that the regular intervals of the feed claws 5 have the same interval dimension as that of the regular intervals of the feed perforations 2. However, the dimension is not limited to the above case but merely required to satisfy the condition of the engagement between the feed claws 5 and the feed perforations 2. For example, instead of the above-mentioned arrangement, it may be the case where the regular intervals of the feed claws 5 are formed so as to have an interval dimension of an integral multiple of that of the regular intervals of the feed perforations 2. Although not shown in the figure, the feed claws 5 are provided with serial numbers, so that each individual feed claw 5 of the feed claws 5 can be specified and identified in, for example, the control device 8.

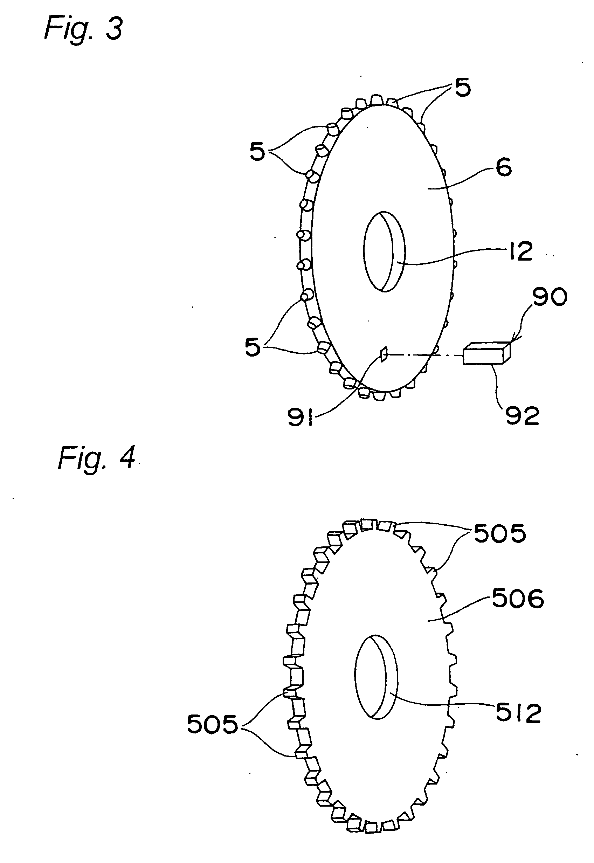

Moreover, as shown in Fig. 2, the motor 7, which is also one example of the rotary driving motor for rotationally driving the feed rotor 6 around its center of rotation, is directly mounted on the feed rotor 6 so as to directly transmit the driving force of the motor 7 to the feed rotor 6, making it possible to rotationally drive the feed rotor 6. Moreover, the motor 7 is provided with an encoder 9 of one example of the rotational position detection device, by which the rotational position in the rotational direction of the feed rotor 6 can be directly detected by the encoder 9. It is to be noted that the rotational position detection device is not limited only to the encoder 9. For example, as shown in the perspective view of the feed rotor 6 in Fig. 3, it may be the case where a detection unit 90 including an object 91 to be detected provided for the feed rotor 6 and a detection section 92 capable of detecting the movement position of this object 91 to be detected is provided.

Moreover, as shown in Fig. 1, the component-feeding member 1 is fed with a cover tape 1a stuck thereon so as to cover the upper portion of the component storage sections 3 in which the electronic components 4 are stored. Therefore, the component feed unit 10 is provided with a conveyance roller 13 for peeling off this cover tape 1a and conveying the cover tape 1a peeled off downwardly of the component feed unit 10 and a conveyance roller motor 14 of one example of the driving device for rotationally driving this conveyance roller 13. In order to enable the intermittent conveyance of the component-feeding member 1, the feed rotor 6 and the conveyance roller 13 are synchronized with each other to carry out the intermittent rotational driving, and this synchronized control is executed by the control device 8.

Moreover, as shown in Fig. 1, the component-feeding member 1 in which the electronic component 4 is exposed on the component storage section 3 as a consequence of the peeling-off of the cover tape 1a is intermittently conveyed so that the conveyance is temporarily stopped in a state in which the planar center of one component storage section 3 on which the electronic component 4 is exposed is positioned in a component pickup position 16 that is the prescribed position in the direction of conveyance of the component-feeding member 1. This component pickup position 16 also serves as a suction and pickup position of the electronic component 4 by a suction nozzle of one example of the component holding member in the component mounting apparatus. When the component storage section 3 is positioned in the component pickup position 16, the electronic component 4 stored in the component storage section 3 is put into a state in which the component can be sucked and picked up by the suction nozzle.

Further, as shown in Fig. 1, the component feed unit 10 is provided with a connector 15 through which the control device 8 interchanges control information with the outside of the unit and a power supply section (not shown).

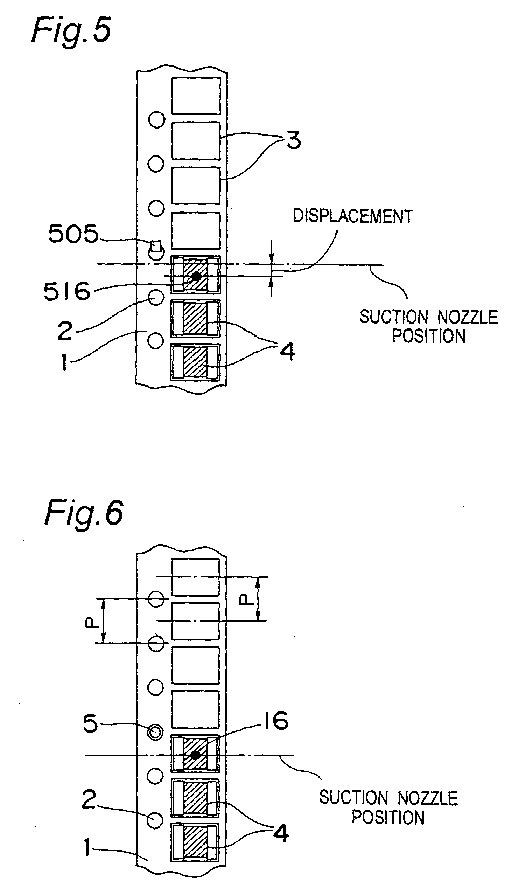

Moreover, the feed perforations 2 of the component-feeding member 1 are each formed roughly into a circular hole shape as shown in Figs. 1 and 2, while the feed claws 5 of the feed rotor 6 capable of being engaged with the feed perforations 2 of the above-mentioned shape are formed into a shape of a roughly circular cross section perpendicular to the radial direction of the feed rotor 6 as shown in the perspective view of Fig. 3. With this arrangement, part of the roughly circular peripheral surface of each feed claw 5 can abut against part of the inner peripheral surface of each feed perforation 2 formed in the circular hole shape. With regard to this, if there are feed claws 505 of a rectangular cross section shape as provided for a conventional feed rotor 506 as shown in Fig. 4, it may be the case where the feed claws 505 of the rectangular cross section bite into the roughly circular feed perforations 2. In the above case, there consequently occurs displacement between a component pickup position 516 and the position of the suction nozzle positioned in the suction and pickup position. In contrast to this, in the case where the component-feeding member 1 is conveyed by the feed claws 5 of the feed rotor 6 of the present first embodiment as shown in Fig. 6, the bite hardly occurs in the mutually abutting portions due to their shapes, and the occurrence of the displacement attributed to the occurrence of the bite can be prevented in advance. As shown in Fig. 6, the formation interval of the component storage sections 3 of the component-feeding member 1 and the formation interval of the feed perforations 2 employed in the present first embodiment have same interval dimension P.

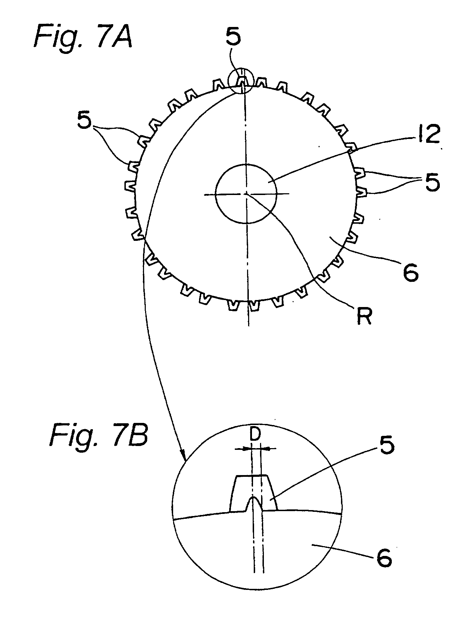

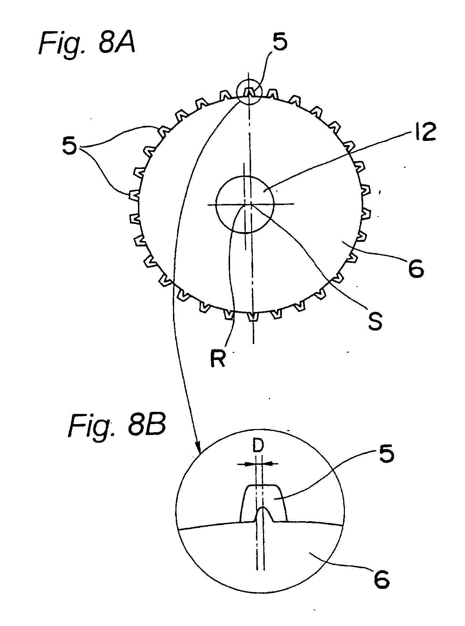

The displacement (or the amount of displacement) of the formation position of the feed claw 5 with respect to the rotational direction or the center of rotation of the feed rotor 6 will be described next with reference to the side views of the feed rotor 6 shown in Figs. 7A and 8A. Figs. 7B and 8B are partially enlarged views of the feed claw 5 of the feed rotor 6 of Figs. 7A and 8A.

In this case, the "amount of displacement" means the amount of displacement of the actual formation position of the feed claws 5 that should be formed on the outer periphery of the feed rotor 6 with respect to the reference formation positions (reference positions) in correspondence with the specified formation interval of the feed perforations 2 of the component-feeding member 1. Moreover, this displacement is also referred to as variation.

Figs. 7A and 7B show the variation (i.e., displacement) ascribed to the indexing accuracy of each of the feed claws 5 of the feed rotor 6. A displacement D occurs in the formation interval of the feed claws 5 due to the machining process and the machining accuracy of the feed claws 5. Moreover, Figs. 8A and 8B show a state in which the displacement D occurs between the center of rotation R of the feed rotor 6 and the center of rotation S of the mounting portion 12 (or the drive shaft of the motor 7) due to the eccentricity of the mounting portion 12 to the motor 7 formed in the vicinity of the center of the feed rotor 6, a gap to the counterpart to be mounted and so on.

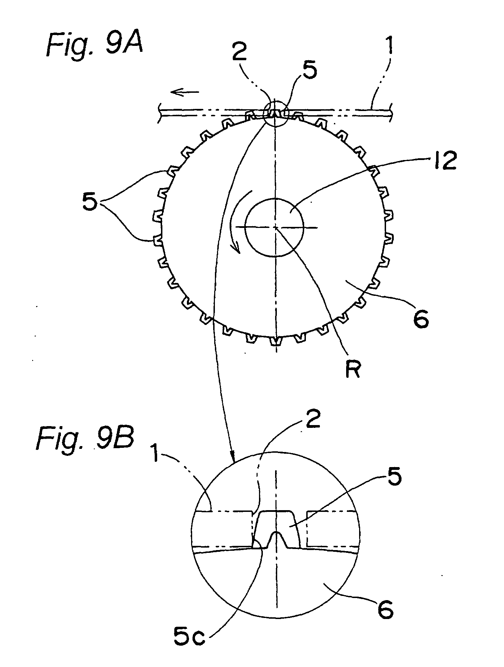

Fig. 9A and Fig. 9B, which is the partially enlarged view of the feed rotor 6 shown in Fig. 9A, show side views of the feed rotor 6 in a state in which the displacement as shown in the states of Figs. 7A and 7B and Figs. 8A and 8B does not occur. As shown in Figs. 9A and 9B, the feed perforations 2 of the component-feeding member 1 are engaged with the feed claws 5 of the feed rotor 6. By rotationally driving the feed rotor 6 in the counterclockwise direction in the figure, the component-feeding member 1 is conveyed in the leftward direction in the figure while bringing a contact portion 5c that is part of the peripheral surface on the left-hand side of the feed claw 5 in the figure in contact with part of the feed perforation 2. That is, the component-feeding member 1 is conveyed in the illustrated leftward direction, which is the rotational direction of the feed rotor 6 in the position where the feed claw 5 of the feed rotor 6 is engaged with the feed perforation 2 of the component-feeding member 1 while bringing part of the peripheral surface of the feed claw 5 and part of the peripheral portion of the feed perforation 2 in contact with each other.

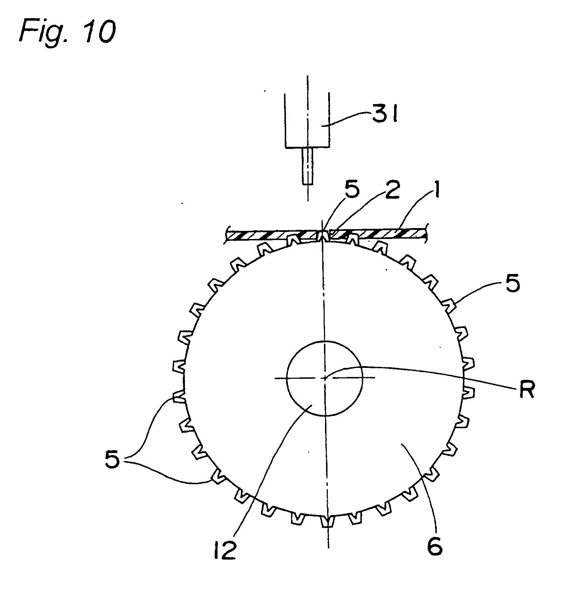

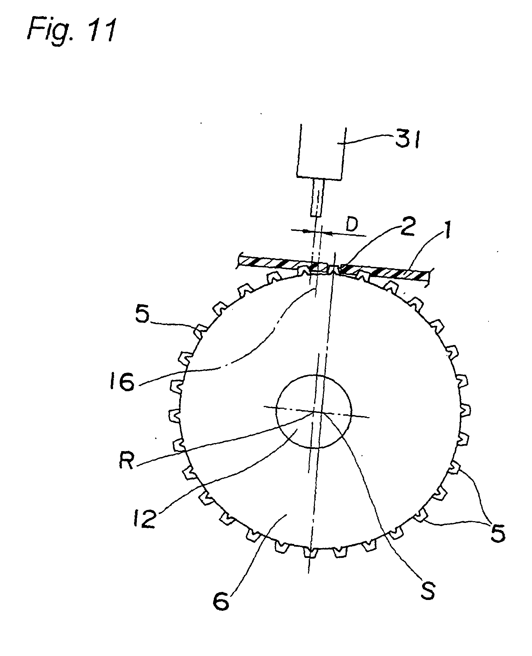

If the feed rotor 6 is rotated in the states as shown in Figs. 7A, 7B, 8A and 8B, then the amount of intermittent feed of the component-feeding member 1 by the feed claws 5 becomes nonuniform, causing displacement in the amount of feed. Originally, as shown in Fig. 9A, it is preferred that the feed claws 5 should be formed with satisfactory indexing accuracy so that the formation interval becomes a regular interval and no displacement should occur between the center of rotation S of the mounting portion 12 and the center of rotation R of the feed rotor 6. In the above case, as shown in Fig. 10, it is possible to intermittently convey the component-feeding member 1 at a constant feeding rate, place the component storage sections 3 successively into the component pickup position 16 and bring the electronic components 4 stored in the suction nozzles 31 securely into a state in which the components can be picked up by the suction nozzle 31. However, a displacement actually occurs as shown in Figs. 7A and 8A, and consequently, the displacement D disadvantageously occurs between the center of the suction nozzle 31 and the center of the component storage section 3, which is positioned in the component pickup position 16, of the component-feeding member 1 as shown in Fig. 11.

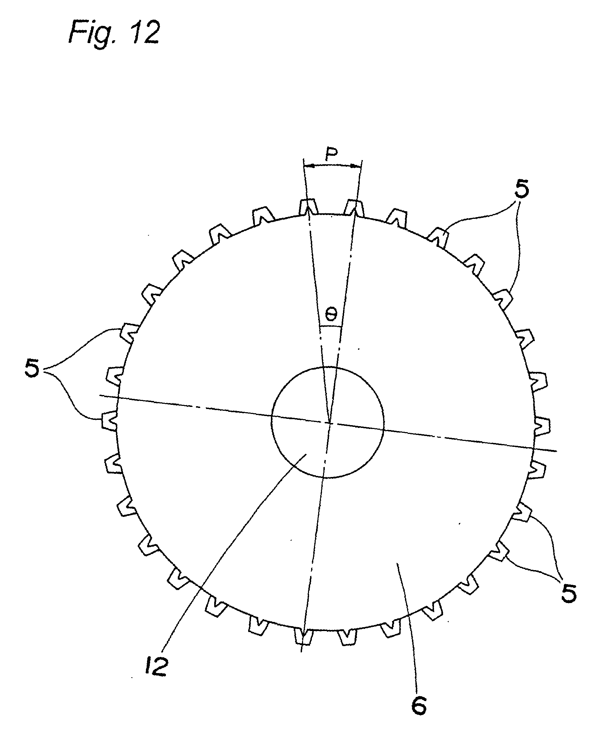

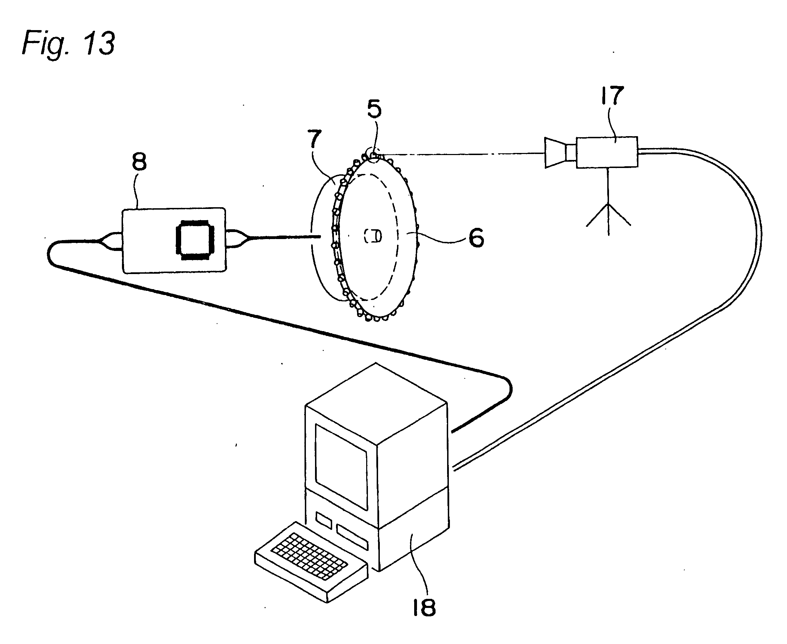

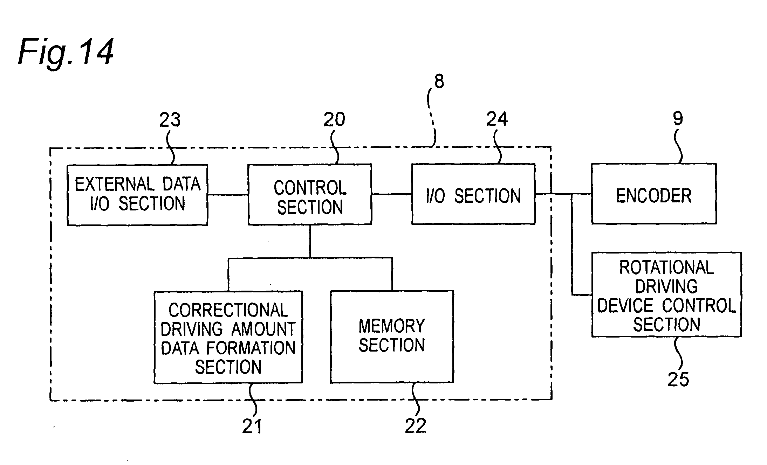

Then, there will be described below a method for performing the component feed with the amount of intermittent feed of the component-feeding member 1 approximately constant even if the above-mentioned displacement D occurs by preparatorily measuring the amount of the displacement, storing data of the measured amount of displacement in the control device 8 and rotationally driving the feed rotor 6 on the basis of the displacement amount data in the control device 8 while correcting the rotational driving amount. Moreover, a side view of the feed rotor 6 is shown in Fig. 12, and a schematic explanatory view for explaining the component feed method is shown in Fig. 13. Further, a control block diagram showing the principal construction of the control device 8, which is provided for the component feed unit 10 and able to carry out the aforementioned method, is shown in Fig. 14.

As shown in Fig. 12, the formation interval of the feed claws 5 owned by the feed rotor 6 coincides with the formation interval P of the feed perforations 2 of the component-feeding member 1. Moreover, due to the feed claws 5 formed on the outer peripheral portion of the component-feeding member 1, the feed claws 5 are formed at a regular formation angle θ corresponding to the formation interval P. For example, when the feed rotor 6 is provided with 30 feed claws 5 as shown in Fig. 12, the formation angle θ becomes 12 degrees.

The construction of the control device 8 will be described next with reference to the control block diagram shown in Fig. 14. It is to be noted that Fig. 14 shows only the main constituent sections of all the constituent sections provided for the control device 8 for the sake of easiness in understanding the explanation, and the detailed construction of the control device 8 should not be interpreted as limited only to the construction shown in Fig. 14.

As shown in Fig. 14, the control device 8 includes a correctional driving amount data formation section 21 that is able to form correctional driving amount data of the feed rotor 6 by correcting the rotational driving amount data (e.g., data for carrying out the aforementioned intermittent feed by rotating each of the feed claws 5 at an angle of 12 degrees in the case of the feed rotor 6 shown in Fig. 12) of each of the feed claws 5 of the feed rotor 6 by the motor 7 on the basis of the displacement amount data of each of the feed claws 5 so that each of the component storage sections 3 of the component-feeding member 1 can be positioned in the component pickup position 16 as well as a memory section 22 of one example of a data retainment section that retrievably retains (i.e., stores) the displacement amount data, the rotational driving amount data of each of the feed claws 5 and the correctional driving amount data formed as above. The control device 8 further includes an external data input/output section 23 of one example of the information input/output section capable of inputting the displacement amount data and the rotational driving amount data from the outside of the component feed unit 10 and outputting the information of externally needed data and so on, an input/output section 24 that interchanges control information between the external data input/output section 23 and a rotary driving device control section 25 that executes driving control of the encoder 9 and the motor 7. The control device 8 further includes a control section 20 provided with a control function of a CPU and so on for supervisorily executes control of the external data input/output section 23, the input/output section 24, the memory section 22 and the correctional driving amount data formation section 21 while correlating them with one another. The control section 20 is able to execute, for example, the control of storing data inputted via the external data input/output section 23 into the memory section 22, the control of retrieving the data stored in the memory section 22 and interchanging the data with the correctional driving amount data formation section 21 and further the control of the rotational driving amount of the motor 7 by means of the rotary driving device control section 25 while retrieving the correctional driving amount data stored in the memory section 22 and verifying the data with the information of the rotational movement position (rotational position) of the feed rotor 6 inputted from the encoder 9. It is to be noted that the external data input/output section 23 is connected to the connectors 15 of the component feed unit 10 shown in Fig. 1.

Next, the schematic explanatory view of Fig. 13 is a figure for explaining one example of a procedure for forming the displacement amount data by measuring the amount of displacement of each of the feed claws 5. As shown in Fig. 13, a camera 17 of one example of the imaging device is able to capture the image of the rotational movement position of each of the feed claws 5 in the rotational direction when the feed rotor 6 is intermittently rotated. Moreover, a personal computer 18 is able to take in the image data captured by the camera 17 and detect the amount of displacement between the rotational movement position of each of the feed claws 5 and the position where each of the feed claws 5 should be positioned on the basis of the corresponding image data, making it possible to form data of the detected amount of displacement. Moreover, the personal computer 18 is connected to the external data input/output section 23 of the control device 8 and is able to take the displacement amount data formed as above into the control device 8.

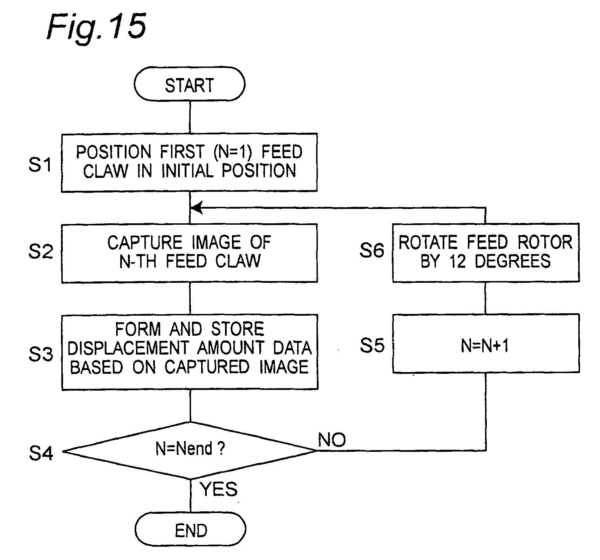

A procedure for measuring the amount of displacement of each of the feed claws 5 by means of the construction as shown in Fig. 13 will be described on the basis of the flow chart shown in Fig. 15. In the following description, when any feed claw 5 among the feed claws 5 provided for the feed rotor 6 shown in Fig. 12 is used specified, the number of the feed claw 5 is represented by the N-th (note that N is an integer of 1 to 30) feed claw 5.

In step S1 of the flow chart shown in Fig. 15, first of all, the first (N = 1) feed claw 5 is positioned in an initial position. In this case, the initial position is the position where the component storage section 3 of the component-feeding member 1 conveyed by the first feed claw 5 can be positioned in the component pickup position 16, serving also as, for example, the position where the first feed claw 5 is positioned in the uppermost portion of the feed rotor 6. It is appropriate in the subsequent measurement procedure to set the above-mentioned position as an origin of rotation (or a reference rotational' position) of the feed rotor 6 detected by the encoder 9.

Next, in step S2, the image of the first feed claw 5 positioned as described above is captured by the camera 17 in a direction perpendicular to the rotational direction of the feed rotor 6, i.e., from a side surface as shown in Fig. 13. Subsequently, in step S3, the image captured by the camera 17 is taken into the personal computer 18 to form the displacement amount data of the first feed claw 5 on the basis of the image, and the formed data is stored. It is to be noted that the direction of capturing the image is not limited to the above-mentioned direction but allowed to be any direction. However, in order to accurately measure the amount of displacement of each of the feed claws 5, it is preferable to capture the image from the direction perpendicular to the rotational direction as described above.

Next, the personal computer 18 determines whether or not the feed claw 5 to be imaged next is remaining or concretely determines whether or not the number N of the feed claw 5 corresponds to the number N_{end} of the last feed claw 5 provided for the feed rotor 6. If there is no correspondence, then the number N of the feed claw 5 is set as N+1 in step S5, and, for example, the second feed claw 5 is selected. Subsequently, in step S6, the feed rotor 6 is rotationally driven at an angle of 12 degrees, or by the formation angle, and the second feed claw 5 is positioned in a position where the component storage section 3 can be positioned in the component pickup position 16 by the second feed claw 5.

Subsequently, in steps S2 and S3, the image of the feed claw 5 is captured, and the displacement amount data thereof is similarly formed. The above-mentioned operation is repetitively carried out in step S4 until the images of all the feed claws 5 are captured.

If it is detected in step S4 that the number N of the feed claw 5 is N_{end}, then the detection operation of the amount of displacement ends.

If the aforementioned operation is explained by a concrete example of numerical values, for example, in the case where a feed rotor 6 having 30 feed claws 5 and a formation angle θ = 12 degrees as shown in Fig. 12 is employed, assuming that the formation position of the first feed claw 5 to be a reference is 0 degree, then the reference formation positions of the feed claws 5 with respect to the reference position are at an angle of 12 degrees in the case of the second feed claw 5, an angle of 24 degrees in the case of the third feed claw 5 and an angle of 36 degrees in the case of the fourth feed claw 5.

On the other hand, the actual formation position of each of the feed claws 5 detected on the basis of the image captured by the camera 17 has displacement, and therefore, the displacement is detected as 0.05 degrees in the case of the first feed claw 5, 12.05 degrees in the case of the second one, 24.1 degrees in the case of the third one and 35.99 degrees in the case of the fourth one. The above-mentioned detection is carried out for all of the 30 feed claws 5, and the respective data are stored as the displacement amount data.

With regard to the detection of the amount of displacement, the amount of displacement can be detected by, for example, detecting the same positions of the end surface portions of the feed claws 5 (for example, the portions 5c of the feed claws 5 brought in contact with the feed perforations 2) or by pattern matching of the shapes of the feed claws 5. For example, the feed rotor 6 is rotationally driven until it is detected that the end surface portion of the feed claw 5 brought in contact with the feed perforation 2 of the component-feeding member 1 is positioned in the position where the portion should originally be positioned, or the prescribed position on the image while imaging the feed claw 5 of the object to be imaged. By storing the value of the rotational movement position of the feed rotor 6 detected by the encoder 9 when the event that the portion is positioned as described above is detected, the amount of displacement can be detected.

In the case where the amount of displacement of the first feed claw is detected as 0.05 degrees, the initial position of the rotational reference position serving as the reference can be corrected to 0.05 degrees for 0 (zero) point adjustment. Although the angle data is used as one example as the amount of displacement in the above description, it is needless to say that the present invention is not limited only to the angle data but allowed to be data of, for example, a distance dimension or the like.

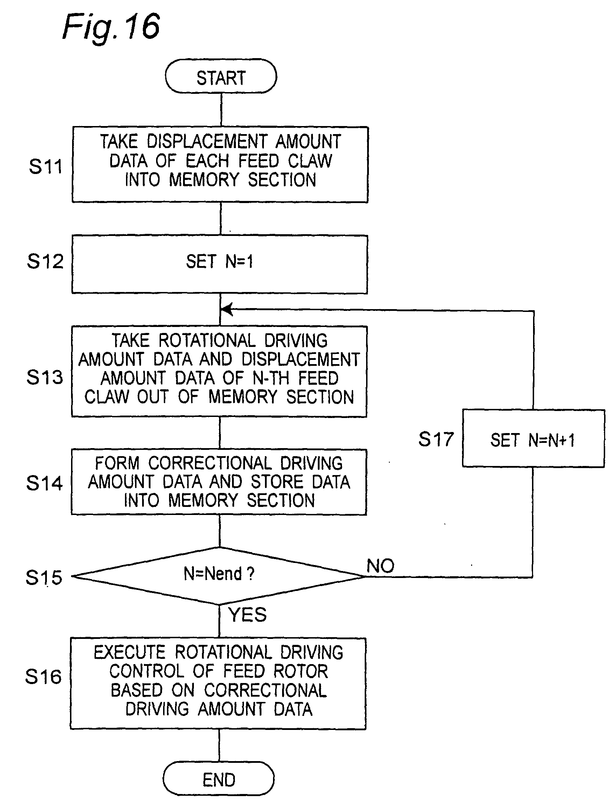

Next, a procedure for forming correctional driving amount data by correcting the rotational driving amount data using the aforementioned displacement amount data will be described with reference to the flow chart shown in Fig. 16.

In step S11 of the flow chart shown in Fig. 16, the displacement amount data of the feed claws 5 previously formed and stored in the personal computer 18 are taken into the memory section 22 through the external data input/output section 23. It is to be noted that means for taking in the data can be provided by various means via a storage medium, radio communications or the like.

Next, the first (N = 1) feed claw 5 is selected in the control section 20 in step S12, and the rotational driving amount data and the displacement amount data of the first feed claw 5 are taken out of the memory section 22 and inputted to the correctional driving amount data formation section 21 in step S13. In this case, the rotational driving amount data is the data when the feed claws 5 are intermittently rotationally driven and also the data preparatorily inputted and stored in the memory section 22.

Next, in step S14, the rotational driving amount data is corrected on the basis of the displacement amount data in the correctional driving amount data formation section 21, and the corrected data is formed as the correctional driving amount data of the first feed claw 5 and stored into the memory section 22.

Subsequently, it is confirmed in step S15 whether or not the selected feed claw is the N_{end}-th last feed claw 5. If the selected feed claw is not the last feed claw 5, then the number N of the feed claw 5 is set to N+1 in step S17, and, for example, the second feed claw 5 is selected. Subsequently, in steps S13 and S14, the rotational driving amount data and the displacement amount data of the second feed claw 5 are taken out of the memory section 22, and the correctional driving amount data of the second feed claw 5 is formed and stored into the memory section 22. The above-mentioned steps are repetitively carried out until the correctional driving amount data of all the feed claws 5 are formed.

On the other hand, if it is confirmed in step S15 that all the feed claws 5 have been selected, then the rotational driving control of the feed rotor 6 is executed or put into an executable state on the basis of the correctional driving amount data in step S16, and the control subsequently ends. The above-mentioned rotational driving control of the feed rotor 6 is executed by detecting the actual rotational movement position of the feed rotor 6 by means of the encoder 9 while carrying out the rotational driving of the motor 7 by means of the rotary driving device control section 25 on the basis of the correctional driving amount data so that the detected rotational movement position coincides with the rotational driving position based on the correctional driving amount data.

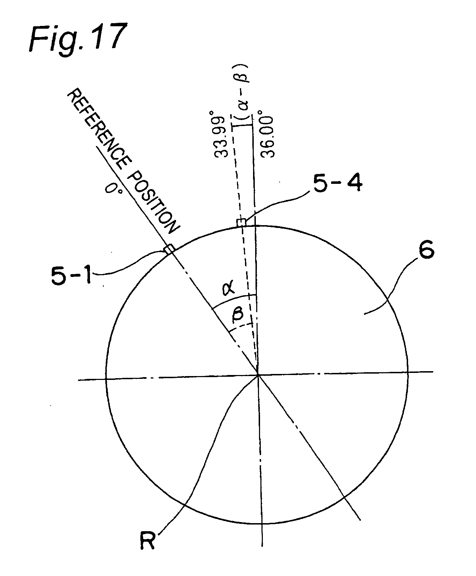

If the aforementioned operation procedure is explained as a concrete example of numerical values by using, for example, the aforementioned concrete example of the amount of displacement, the amount of displacement of each of the feed claws 5 is calculated by calculating a difference between the displacement amount data of 0.05 degrees, 12.05 degrees, 24.1 degrees and 35.99 degrees of the first through fourth feed claws 5 and the respective formation angles in the reference formation positions of the feed claws 5. Then, the amounts of displacement become 0.05 degrees, 0.05 degrees, 0.1 degrees and -0.01 degrees. For example, assuming that the first feed claw 5-1 is located at, for example, the reference formation position of 0 degree in the schematic explanatory view shown in Fig. 17, then the formation angle of the fourth feed claw 5-4 with respect to this reference formation position becomes α = 36.00 degrees. On the other hand, the actual formation angle of the fourth feed claw 5-4 is β = 35.99 degrees, and therefore, the amount of displacement becomes a difference between them, i.e., α - β = 0.01 degrees. However, in this case, because of the displacement in the direction toward the reference formation position of the first feed claw 5 (i.e., the counterclockwise direction in the figure), the displacement becomes -0.01 degrees including the negative sign. By adding each of these displacement amount values to 12 degrees of the regular formation angle θ of the feed claws 5, the correctional driving amount data of the feed claws 5 are formed so as to become 12.05 degrees, 12.05 degrees, 12.1 degrees and 11.99 degrees. That is, the correctional driving amount data can be obtained by the equation: (correctional driving amount data) = (formation angle θ) + (amount of displacement).

The method for forming the correctional driving amount data as described above is a method for individually correcting the individual driving amount data. As another method, there is also a method for correcting the absolute value of the rotational movement position of each of the feed claws 5 in the rotational direction of the feed rotor 6. If explanation is made by using a concrete example, with the displacement amount data of the first through fourth feed claws 5, i.e., 0.05 degrees, 12.05 degrees, 24.1 degrees and 35.99 degrees as the data of the respective rotational movement positions as they are, the correctional driving amount data are formed as 0.05 degrees, 12.05 degrees, 24.1 degrees and 35.99 degrees. Subsequently, in rotationally moving the feed claws 5, the rotational driving amount of the feed rotor 6 is controlled so as to achieve the rotational movement positioning corresponding to the correctional driving amount data. In the case where the method for correcting the absolute values of the rotational movement positions of the feed claws 5 is adopted as described above, it is possible to obviate the need for calculating the correctional driving amount data in individually correcting the individual drive amount data. Therefore, the processing time can be shortened, and the absolute values of the corrected rotational movement positions can be used in rotationally driving the feed rotor 6. This has an advantage that the control can be made simple.

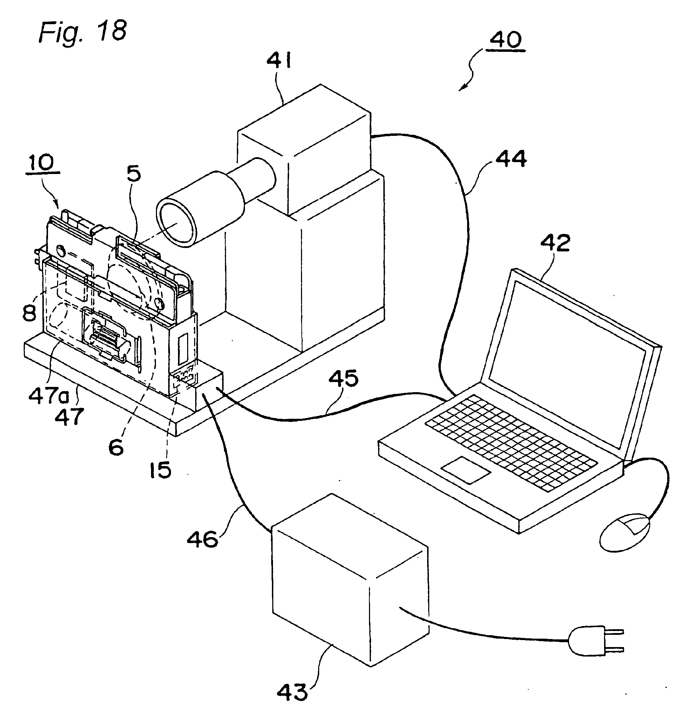

Next, a feed claw displacement amount measurement device 40 of one example of the feed claw displacement amount measurement device capable of more easily carrying out a method for correcting the rotational driving amount by detecting the amount of displacement of each of the feed claws 5 will be described with reference to the perspective view shown in Fig. 18.

As shown in Fig. 18, the feed claw displacement amount measurement device 40 includes a mounting base 47 provided with a mounting portion 47a of one example of the retainment portion capable of removably mounting the component feed unit 10 and a camera 41 of one example of the imaging device that bears a role similar to that of the camera 17 shown in Fig. 13 while being supported on the mounting base 47 and captures the image of each of the feed claws 5 of the component feed unit 10 mounted on the mounting portion 47a. The feed claw displacement amount measurement device 40 further includes a personal computer 42 provided with both of a displacement amount data formation section for forming the displacement amount data of each of the feed claws 5 on the basis of each of the images captured by the camera 41 and a data output section for outputting the formed displacement amount data to the control device 8 of the component feed unit 10. Moreover, this personal computer 42 is connected to the camera 41 via a communication cable 44 capable of executing communications of image data and also connected to the component feed unit 10 via a communication cable 45 capable of transmitting the displacement amount data to the control device 8. Moreover, the connectors 15 of the component feed unit 10 are connected to the communication cable 45 as well as a power supply cable 46 connected to a power supply 43.

In the feed claw displacement amount measurement device 40 of the aforementioned construction, by capturing the image of each of the feed claws 5 according to a procedure similar to the procedure shown in the flow chart of Fig. 15, the displacement amount data of each of the feed claws 5 can be formed. The formed displacement amount data can be stored and retained in the personal computer 42 and also inputted and stored in the memory section 22 inside the control device 8 through the data output section inside the personal computer 42 and the communication cable 45.

The detection (measurement) of the amount of displacement of each of the feed claws 5 may be carried out before the shipping of the unit on the manufacturer side of the component feed unit 10 by means of a special measurement device of, for example, the feed claw displacement amount measurement device 40 or carried out after the shipping of the unit to the user of the unit on the user side of the component feed unit 10 by means of a special measurement device of, for example, the feed claw displacement amount measurement device 40. Moreover, it is, of course, possible to carry out the detection without using the special measurement device as described above if the constituent devices of the camera 17 and the personal computer 18 as shown in Fig. 13 are used.

Although the control device 8 is provided with the correctional driving amount data formation section 21 according to the description in connection with the block diagram of the control device 8 of the component feed unit 10 shown in Fig. 14, it may be the case where the correctional driving amount data formation section 21 is not provided instead of the above-mentioned case. This is for the reason that the rotational driving control of the feed rotor 6 can be similarly executed by the correctional driving amount data by forming the correctional driving amount data on the basis of the displacement amount data in another control device, computer or the like provided with the function possessed by the correctional driving amount data formation section 21 as described above, inputting the formed correctional driving amount data into the control device 8 and retaining the data in the memory section 22.

According to the first embodiment, intermittent feed amount control of the component-feeding member 1 can be achieved so that the amount of displacement in the formation position of each of the feed claws 5 formed on the outer periphery of the feed rotor 6 that conveys the component-feeding member 1 for the component feed is measured in the component feed unit 10 with respect to the rotational direction or the center of rotation R of the feed rotor 6, the correctional driving amount data of each of the feed claws 5 is formed on the basis of the displacement amount data formed on the basis of the measured amount of displacement, and each of the component storage sections 3 is securely positioned in the component pickup position 16 on the basis of the correctional driving amount data.

That is, even if there is variation in the formation position of each of the feed claws 5 in the feed rotor 6 or there is displacement between the center of rotation R of the feed rotor 6 and the center of rotation S of the motor 7, by detecting the amount of displacement in the formation position of each of the feed claws 5 attributed to the variation and displacement and executing the control of the rotational driving amount of the feed rotor 6 in consideration of this amount of displacement, the intermittent feed amount of the component-feeding member 1 can be made constant regardless of the formation position accuracy of each of the feed claws 5 and so on.

Therefore, the continuous feed of the electronic components 4 can be achieved stably with high accuracy in the component feed unit 10.

Moreover, as shown in Fig. 2, the motor 7 is mounted directly on the feed rotor 6 without intervention of a gear or the like. Accordingly, there occurs no play of backlash or the like, and the component-feeding member 1 can be intermittently fed consistently with the prescribed pitch.

Furthermore, as shown in Fig. 2, the rotational movement position of the feed rotor 6 is directly detected instead of detecting the rotational movement position of the motor 7 by the encoder 9, and therefore, the position in the rotational direction of the feed rotor 6 can be always made definite. Therefore, the rotational movement position of each of the feed claws 5 formed on the feed rotor 6 can be perceived individually and accurately, and the variation in the feed of each of the feed claws 5 can be accurately corrected. This can also be similarly achieved by using a detection device 90 provided with the aforementioned detection section 91 in place of the encoder 9.

### (Second Embodiment)

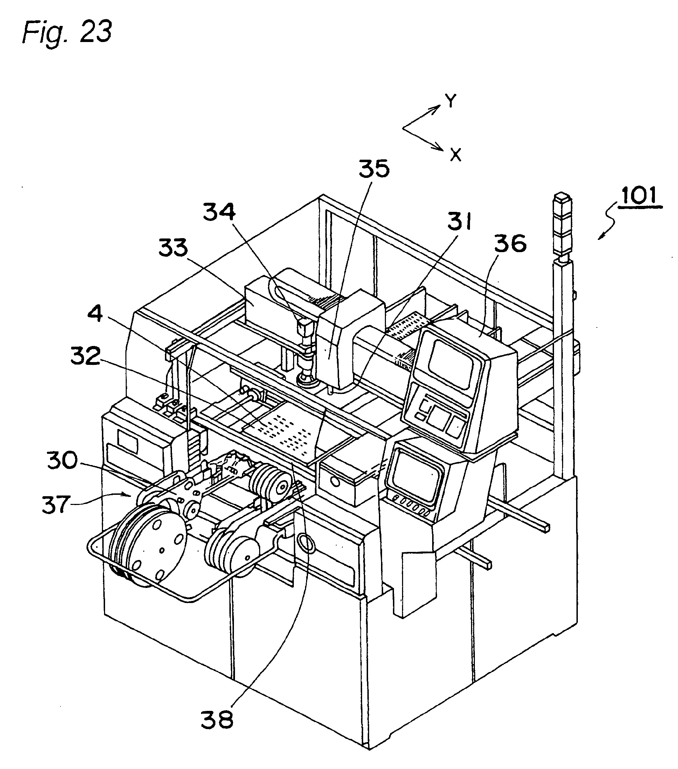

The present invention is not limited to the aforementioned embodiment but allowed to be provided in other various forms. For example, a perspective view of an electronic component mounting apparatus 101 of one example of the component mounting apparatus according to the second embodiment of the present invention is shown in Fig. 23.

As shown in Fig. 23, the electronic component mounting apparatus 101 is the apparatus that releasably sucks and holds a plurality of electronic components 4 fed from the component feed unit 10 of the first embodiment by means of the suction nozzle 31 of one example of the component holding member and mounts the components on the surface of a board 32. As shown in Fig. 23, the electronic component mounting apparatus 101 includes a component feed section 37 provided with a plurality of removably arranged component feed cassettes 30 of one example of the component feed device provided with a component feed unit 10, a suction nozzle 31 capable of releasably sucking and holding the electronic component 4 fed from this component feed section 37, a head section 35 that supports this suction nozzle 31 provided in its lower portion, an X-Y robot 33 of one example of the positioning device that moves the head section 35 in an X-direction or a Y-direction, which are the directions roughly parallel to the surface of the illustrated board 4 and further includes a board holding section 38 that releasably holds the board 32. It is to be noted that the illustrated X-direction and Y-direction are the directions perpendicular to each other in Fig. 23.

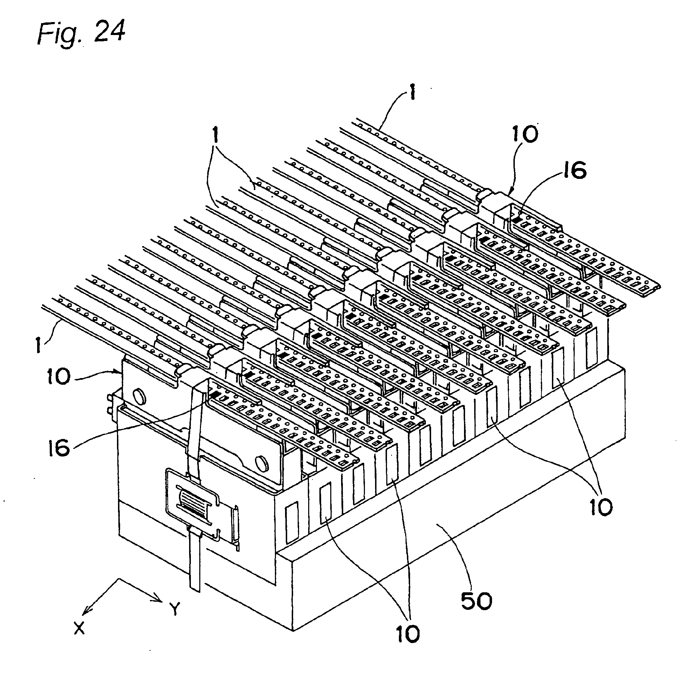

In this connection, a partially enlarged perspective view of the component feed section 37 is shown in Fig. 24. As shown in Fig. 24, a total of ten component feed units 10 provided for a plurality of component feed cassettes 30 are mutually adjacently arranged in the illustrated X-direction in the component feed section 37. Moreover, the component feed units 10 are provided while being removably positioned on a mounting base 50 in the component feed section 37. Further, the component feed units 10 are arranged so that the respective component pickup positions 16 are arrayed at regular intervals in a line along the illustrated X-axis direction.

Moreover, the head section 35 is provided with a board recognition camera 34 of one example of the board recognition device capable of recognizing the mounting position by capturing the image of the mounting position of the electronic component 4 on the surface of the board 32. By moving the head section 35 in the X-direction or the Y-direction by means of the X-Y robot 33, the board recognition camera 34 is moved so as to scan the surface of the board 32, allowing the image of the prescribed mounting position to be captured by the board recognition camera 34.

As shown in Fig. 23, the electronic component mounting apparatus 101 includes a mounting control device 36 of one example of the control device that supervisorily executes control while correlating the operations of feed operation of the electronic components 4 by the component feed section 37, sucking and holding operation and hold release operation of the electronic component 4 and the mounting operation of the electronic component 4 by the suction nozzle 31, movement operation of the head section 35 by the X-Y robot 33 and the imaging operation by the board recognition camera 34.

When mounting the electronic component 4 onto the board 32 in the electronic component mounting apparatus 101 of the aforementioned construction, the component-feeding member 1 is conveyed by the component feed cassette 30 that stores the electronic component 4 to be mounted onto the board 32, and the electronic component 4 is positioned in the component pickup position 16 in the component feed section 37.

On the other hand, the head section 35 is moved to a place above the component feed section 37 by the X-Y robot 33, and the positioning of the suction nozzle 31 and the component pickup position 16 where the electronic component 4 is sucked and held is carried out.

Subsequently, the suction nozzle 31 is moved down to bring its end in contact with the upper surface of the electronic component 4 and suck and hold the component, and the electronic component 4 is subsequently sucked and picked up from the component pickup position 16 by moving up the suction nozzle 31.

Subsequently, the head section 35 is moved by the X-Y robot 33 to a place above the board 32 held by the board holding section 38, and the electronic component 4 held by the suction nozzle 31 is aligned in position with the mounting position on the board 32. It is to be noted that the mounting position may be recognized by imaging the mounting position by the board recognition camera 34 before this positional alignment.

Subsequently, by moving down the suction nozzle 31 to bond the electronic component 4 in the mounting position of the board 32, releasing the suction and holding and then moving up the suction nozzle 31, the mounting of the electronic component 4 onto the board 32 is completed.

When mounting a plurality of electronic components 4 onto the board 32, the mounting operation of the electronic components 4 is achieved by repetitively carrying out the aforementioned operation.

During the mounting of the electronic component 4 as described above, the rotational driving amount is previously corrected on the basis of the displacement amount data of each feed claw 5 of the feed rotor 6 in each component feed unit 10 as described in connection with the first embodiment, and therefore, the intermittent feed operation of the component-feeding member 1 can be carried out at a constant feeding rate. Therefore, the electronic components 4 can be securely positioned in the respective component pickup positions 16, and the suction and pickup of the electronic components 4 can be carried out securely and stably.

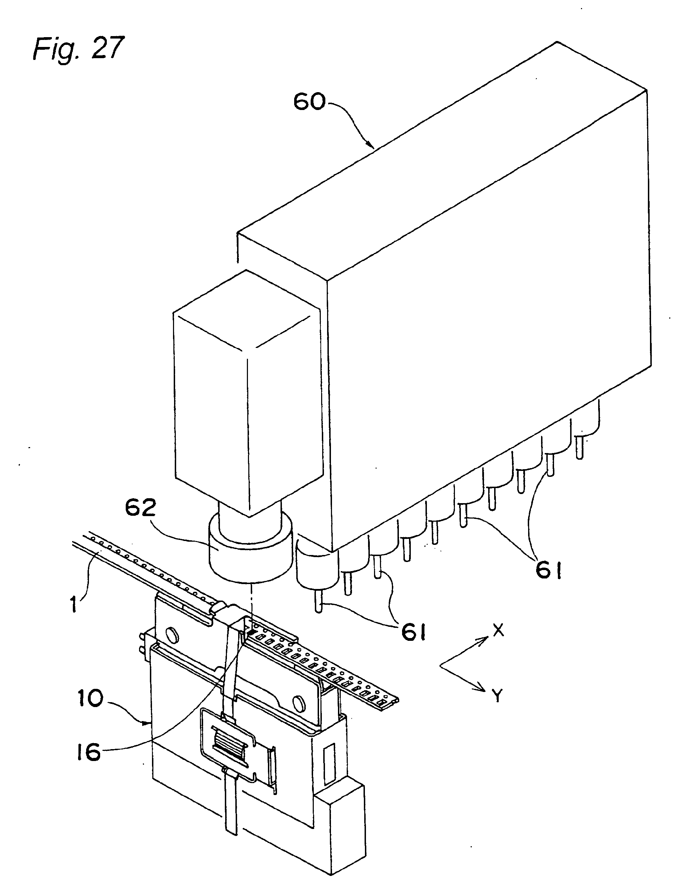

A modification example of the electronic component mounting apparatus 101 of the present second embodiment will be described next. In the aforementioned electronic component mounting apparatus 101, the head section 35 is provided with one suction nozzle 31 according to the description. However, the electronic component mounting apparatus of the present second embodiment is not limited only to the aforementioned case but allowed to have, for example, a head section provided with a plurality of suction nozzles. As one example of the above case, a perspective view of a head section 60 provided with a plurality of suction nozzles 61 of one example of the component holding member is shown in Fig. 27.

As shown in Fig. 27, the head section 60 is provided with ten suction nozzles 61 in its lower portion, and the suction nozzles 61 are arrayed at regular intervals in a line along the illustrated X-direction. The regular arrangement intervals of the suction nozzles 61 have the same dimension as that of the regular arrangement intervals of the component feed units 10 shown in Fig. 24. With this arrangement, the plurality of suction nozzles 61 can be concurrently arranged above the plurality of component pickup positions 16. Therefore, a plurality of electronic components 4 can be concurrently sucked and picked up, so that efficient component mounting can be carried out.

Moreover, as shown in Fig. 27, the head section 60 is provided with a board recognition camera 62 of one example of the board recognition device on its side surface. This board recognition camera 62 is provided for the purpose of accurately recognizing the mounting position of the electronic component 4 by imaging the mounting position of the component on the board 32. However, in addition to the above-mentioned use, by imaging the position of the component pickup position 16 in the component feed unit 10, the position of the component pickup position 16 can be accurately recognized.

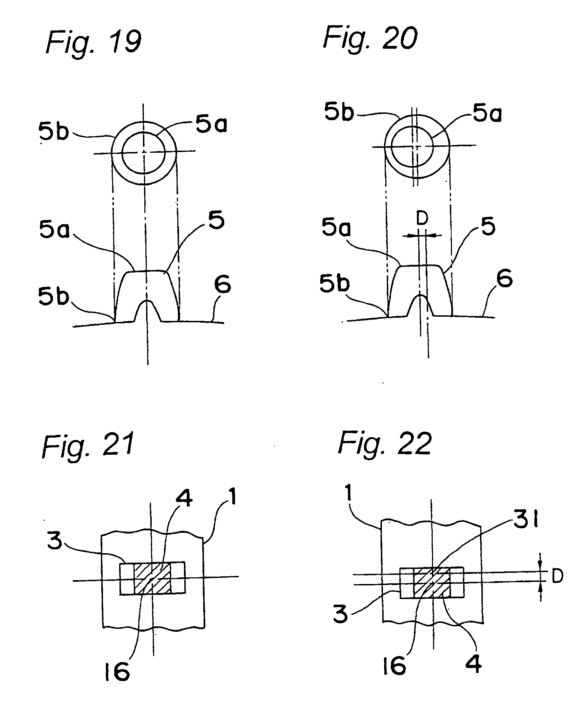

For example, as shown in Fig. 22, the image of the electronic component 4 (or possibly the component storage section 3) positioned in the component pickup position 16 of the component feed unit 10 is captured by the board recognition camera 62. On the basis of this image capturing result, the amount of displacement D between the center position of the electronic component 4 and the component pickup position 16 is calculated as distance data. The above-mentioned calculation is carried out by the mounting control device 36 of the electronic component mounting apparatus 101, the board recognition camera 62 and so on. The amount of displacement D as the calculated distance data is inputted to the control device 8 of the component feed unit 10 that feeds the electronic component 4. The amount of displacement D as the input distance data is converted into an amount of angular displacement, and correctional driving amount data can be subsequently formed according to a procedure similar to the procedure described in connection with the first embodiment.

In this case, assuming, for example, that the amount of displacement as distance data is δL, the amount of displacement as angle data is δθ and a dimension from the component pickup position 16 to the center of rotation R of the feed rotor 6 (i.e., approximately corresponding to the radius of the feed rotor 6) is X, then the conversion of the distance data into the angle data can be calculated by the equation: δθ = δL·360/2πX. Fig. 21 shows the state of the component pickup position 16 when the amount of displacement is 0 (zero).

Moreover, the image capturing of the component pickup position 16 for the calculation of the amount of displacement by the board recognition camera 62 should preferably be the image capturing of the electronic component 4 or the component storage section 3 as described above. For example, it is also possible to capture the image of the feed claws 5 of the feed rotor 6 from the upper side as shown in Figs. 19 and 20. However, when the feed claw 5 is formed into a roughly tapered shape, there are not a few cases in which the center position of a claw lower portion 5b and the center position of a claw upper portion 5a do not coincide with each other. In the above case, as shown in Fig. 20, it is sometimes difficult to detect the amount of displacement D as the distance data. Fig. 19 shows the state of the feed claw 5 when the amount of displacement is 0 (zero).

A method for correcting the mutual displacement of the component pickup positions 16, which are to be arrayed in a line, by means of the aforementioned board recognition camera 62 will be described next.

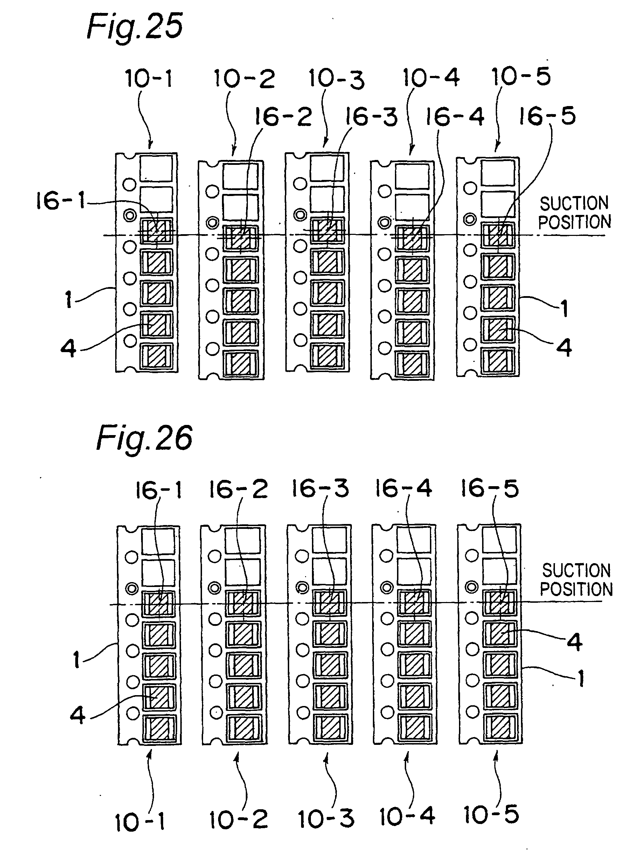

Reference is made to the case where, for example, five component feed units 10 are arrayed at regular intervals in a line as shown in Fig. 25. In the case where each of the component feed units 10 is used specified in Figs. 25 and 26, the component feed units are denoted as component feed units 10-1, 10-2, ..., 10-4, 10-5 from the left-hand side to the right-hand side in the figure. Moreover, the component pickup positions 16 are denoted as component pickup positions 16-1, 16-2, ..., 16-4, 16-5 in the same order as above.

As shown in Fig. 25, the component feed units 10 are arranged so that the component pickup positions 16 are arrayed in a line. However, due to the displacement of the mounting position with respect to the component feed units of the electronic component mounting apparatus and so on, it is sometimes the case where the component pickup positions 16 are arrayed not in a line. In the above case, as shown in Fig. 27, it is difficult to concurrently arrange the plurality of suction nozzles 61 among the suction nozzles 61 similarly arrayed in a line in the plurality of component pickup positions 16, and it becomes impossible to carry out the high-accuracy stable suction and pickup of the plurality of electronic components 4.

In the above-mentioned case, by first placing the board recognition camera 62 provided for the head section 60 shown in Fig. 27 above the component pickup position 16-1 of the component feed unit 10-1 and capturing the image of the position, the amount of displacement between the suction and pickup position of one example of the holding and pickup position of the suction nozzle 61 and the component pickup position 16-1 is calculated.

Next, by placing the board recognition camera 62 above the component pickup position 16-2 of the component feed unit 10-2 and capturing the image of the position, the amount of displacement between the suction and pickup position of the suction nozzle 61 and the component pickup position 16-2 is calculated. By carrying out similar operation for the component feed cassettes 10-3 through 10-5, the amount of displacement between each of the component pickup positions 16-3 through 16-5 and the component suction and pickup position is calculated. It is to be noted that the above-mentioned calculation is carried out by the mounting control device 36 of the electronic component mounting apparatus and the board recognition camera 62.

Subsequently, the displacement amount data are inputted to the control devices 8 of the respective component feed units 10. Each of the control devices 8 is able to form correctional driving amount data by converting the amount of displacement as the distance data into the amount of displacement as angle data, correct, for example, a rotational reference position that is the origin of rotation of the feed rotor 6 on the basis of the correctional driving amount data and carry out correction so as to position the component pickup positions 16 into the respective suction and pickup positions as shown in Fig. 26. In order to enable the correction of the amount of displacement as described above, the motor 7 can be rotationally driven in either of the forward and reverse rotational directions in each of the component feed units 10.

Moreover, in each of the control devices 8, the correctional driving amount data for making the component pickup positions 16 coincide with the suction and pickup positions may be stored and retained as initial position information of the feed claws 5 in the memory section 22.

Moreover, the calculation of the amount of displacement by capturing the image of the component pickup position 16 by means of the board recognition camera 62 is not limited to the calculation carried out by the board recognition camera 62. For example, instead of the above-mentioned case, it may be the case where, the electronic component mounting apparatus is provided with a component recognition camera of one example of the component recognizing device for recognizing the held posture of the electronic component 4 sucked and held by the suction nozzle 61 by capturing the image of the sucked and held posture and similar operation is carried out by the component recognition camera. In concrete, by calculating the amount of displacement between the center of the electronic component 4 that is sucked and held and the center of the suction nozzle 61 by means of the component recognition camera, similar correction of the amount of displacement can be achieved with the calculated amount of displacement regarded as it is as the amount of displacement between the component pickup position 16 and the suction and pickup position in the component feed unit 10.

As described above, when the amount of displacement is corrected by the board recognition camera 62 or the aforementioned component recognition camera provided for the electronic component mounting apparatus, the correction operation of the amount of displacement can be carried out in the series of mounting operation of the electronic component 4 onto the board 32 without stopping the feed of the electronic components 4 by the respective component feed units 10. Accordingly, there is an advantage that efficient component mounting can be achieved without stopping the apparatus operation.

Moreover, with regard to the correction operation of the amount of displacement, the correction of the displacement has been carried out by inputting the displacement amount data to the control device 8 of the component feed unit 10 and forming the correctional driving amount data necessary for the correction in the control device 8 on the basis of the formed correctional driving amount data. However, instead of the above-mentioned case, it may be the case where the correction of the displacement is carried out by directly rotationally driving the motor 7 by a prescribed amount with a signal inputted from the outside of the control device 8. For example, it can be considered the case where the control of the rotational driving amount of the component feed unit 10 is carried out by the mounting control device 36 of the electronic component mounting apparatus 101.

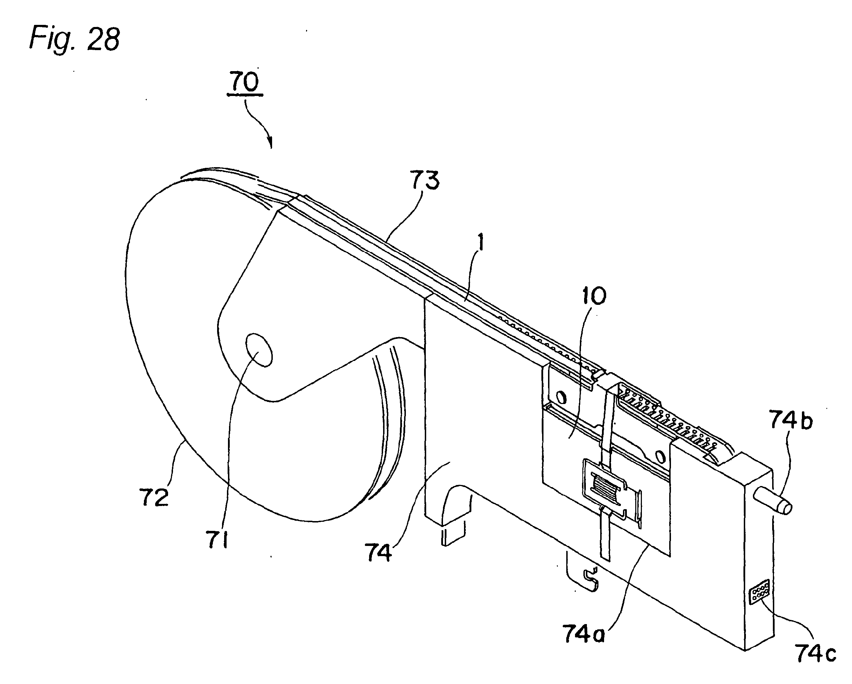

A perspective view of a component feed cassette 70 of one example of the component feed device removably provided with the component feed unit 10 is shown in Fig. 28, and this component feed cassette 70 will be described next.

As shown in Fig. 28, the component feed cassette 70 includes a cassette main body 74 provided with a unit installation section 74a of one example of the unit retainment section removably equipped with the component feed unit 10, a reel retainment portion 71 that is provided for this cassette main body 74 and rotatably removably retains a component feed reel 72 around which the component-feeding member 1 is wound and stored, and a conveyance passage 73 that conveys the component-feeding member 1 unwinded and fed from the component feed reel 72 supported by this reel retainment portion 71 while allowing the component-feeding member 1 to be conveyed to an upper portion of the component feed unit 10. Further, a power supply section 74b and a connector 74c for executing information communications of data and so on are provided on the right-hand side of the cassette main body 74 in the figure. The component feed unit 10 can be supplied with electric power through this power supply section 74b, and this connector 74c is connected to the connector 15 of the component feed unit 10, allowing the information to be transmitted to the control device 8 via the connector 74c.

By arranging a plurality of the component feed cassettes 70 and removably mounting the cassettes on the electronic component mounting apparatus 101 or the like as shown in Fig. 23, continuous feeding of the electronic components 4 can be achieved by the component feed unit 10.

According to the second embodiment, by equipping the component feed section 37 of the electronic component mounting apparatus 101 in which the mounting of the electronic components 4 onto the board 32 is carried out with the component feed units 10 of the first embodiment, there can be provided an electronic component mounting apparatus that is able to continuously feed the electronic components 4 stably with high accuracy during the mounting of the electronic components 4 and also able to cope with, in particular, the mounting of miniaturized electronic components 4.

Moreover, by imaging the component pickup position 16 in the component feed unit 10 utilizing the board recognition cameras 34 and 62 provided for recognizing the mounting position on the board 32 and the imaging device, such as the component recognition camera provided for recognizing the posture of the electronic component 4 sucked and held, provided for the electronic component mounting apparatus, the amount of displacement of each of the feed claws 5 of the feed rotor 6 can be detected. Therefore, the amount of displacement can be detected even without the provision of an imaging device specially for detecting the amount of displacement of the feed claws 5 like the camera 41 of the feed claw displacement amount measurement device 40 and the camera 17 of Fig. 13 dissimilarly to the first embodiment.

Moreover, by detecting the amount of displacement by the aforementioned method, the detection can be performed while carrying out the component mounting operation by the electronic component mounting apparatus 101, and the stop of the apparatus operation for the detection of the amount of displacement can be eliminated. Therefore, efficient component mounting can be achieved.

Moreover, in the case where the electronic component mounting apparatus is equipped with a plurality of component feed units 10 so that the component pickup positions 16 are arrayed in a line, there is the problem that the component pickup positions 16 cannot sometimes be arrayed in a line due to the displacement of the mounting portions for the equipment. Even in the above case, the amount of displacement with respect to the suction and pickup position can be detected by imaging each of the component pickup position 16 by the board recognition camera 62 or the like, and the amount of displacement can be corrected in each of the component feed units 10 on the basis of the detected data. Therefore, even when the displacement occurs, the component pickup positions 16 can be securely arrayed in a line by the aforementioned correction operation. By this operation, it becomes possible to concurrently arrange, for example, the plurality of suction nozzles 61 provided for the head sections 60 above the plurality of component pickup positions 16 and carry out the concurrent suction and pickup of the electronic components 4 stably with high accuracy.

Moreover, it is possible to carry out the correction of the displacement of the feed claws 5 at need in the control device 8 of each of the component feed units 10. With this arrangement, the aforementioned correction can be selectively carried out according to the type of the electronic component 4 to be fed in the electronic component mounting apparatus 101 in, for example, a manner that the electronic component 4 is fed as it is without carrying out the aforementioned correction for a general-purpose electronic component 4 that does not require high mounting position accuracy and the electronic component 4 is fed by selectively carrying out the correction for an electronic component 4 that requires high mounting position accuracy.

According to the first aspect of the present invention, the control section retains the correctional driving amount data of the rotational driving amount of the feed rotor formed based on the displacement amount data of the formation position of each of the feed claws with respect to the rotational direction or the center of rotation of the feed rotor that conveys the component-feeding member in a component feed unit, and the control section is able to control the rotational driving amount of the feed rotor so that the components stored in the component-feeding member are successively positioned into the component pickup position on the basis of the correctional driving amount data. With this arrangement, the displacement of each of the feed claws occurring in the process of forming the feed claws or the process of assembling the component feed unit can be corrected in a control manner. Therefore, the mechanically occurring displacement can be corrected in a control manner to allow the mechanical displacement to be eliminated in a pseudo manner. Therefore, the components in the component-feeding member can be conveyed to the component pickup position stably with high accuracy, and stable component feed can be achieved.

According to the second aspect of the present invention, the displacement amount data are the data formed based on the actual rotational movement position of each of the feed claws in the rotational direction of the feed rotor when the feed rotor is rotationally driven by the rotary driving device so that each of the components is positioned in the component pickup position and the position where the feed claw should be positioned. With this arrangement, the amount of displacement of each of the feed claws can be accurately corrected with the correctional driving amount data formed based on the displacement amount data, and stable high-accuracy conveyance of the component-feeding member can be achieved.

According to the third aspect of the present invention, in the component feed unit, the control section includes the correctional driving amount data formation section which forms the correctional driving amount data of the feed rotor by correcting the rotational driving amount data of each of the feed claws of the feed rotor by the rotary driving device capable of positioning each of the components in the component pickup position on the basis of the displacement amount data and the data retainment section which retrievably retains the displacement amount data, the rotational driving amount data and the correctional driving amount data. With this arrangement, by inputting the displacement amount data of each of the feed claws to the control section, the displacement of each of the feed claws can be corrected.

According to the fourth aspect of the present invention, the amount of displacement is the amount of displacement of the actual formation position with respect to the reference position of each of the feed claws that should be formed on the outer periphery of the feed rotor in correspondence with the regular formation intervals of the feed perforations of the component-feeding member. With this arrangement, by carrying out the above-mentioned correction, high-accuracy stable conveyance of the component-feeding member, i.e., stable feed of the components can be achieved.

According to the fifth aspect of the present invention, the control section is able to detect the rotational position of the feed rotor and controls the rotational driving amount of the feed rotor by the rotary driving device while carrying out the detection. By this operation, the control section can securely grasp the amount of the rotational driving of the feed rotor and the actual amount of the rotational driving of the feed rotor. Therefore, the rotational driving amount of the feed rotor can be accurately controlled on the basis of the correctional driving amount data, and high-accuracy stable feed of the components can be achieved.

According to the sixth or seventh aspect of the present invention, the rotational position of the feed rotor can be directly detected by using the encoder and the detection divide, and accurate detection can be achieved.

According to the eighth aspect of the present invention, the cross section of each of the feed claws is not formed into the rectangular shape as in the conventional case but formed into the roughly circular shape. With this arrangement, the contact portion of the feed claw can be made to hardly bite into the feed perforation, and high-accuracy stable conveyance of the component-feeding member can be achieved.

According to the ninth aspect of the present invention, the rotary driving device has a rotary driving motor which is connected directly to the feed rotor and directly rotationally drives the feed rotor. With this arrangement, the occurrence of driving position displacement due to backlash or the like can be prevented in comparison with, for example, the case of intervention of drive transmitting section of bevel gears or the like, and the rotational driving of the feed rotor can be accurately securely achieved.

According to the tenth aspect of the present invention, the control section is able to correct the rotational reference position of the feed rotor on the basis of the correctional driving amount data. With this arrangement, it becomes possible to carry out the correction while correlating, for example, the rotational reference positions of a plurality of component feed units arrayed in alignment and to cope with various modes by improving the flexibility of the correction.

According to the eleventh aspect of the present invention, a component feed device removably equipped with the component feed unit that has the aforementioned effects can be provided.

According to the twelfth aspect of the present invention, by means of the feed claw displacement amount measurement device provided with the imaging device for capturing the image of each of the feed claws, the displacement amount data formation section for forming the displacement amount data on the basis of the captured image and the data output section for outputting the formed displacement amount data to the control section of the component feed unit, the amount of displacement can be measured more easily. Therefore, by using the above-mentioned feed claw displacement amount measurement device, the measurement can easily be achieved not only on the manufacturer side of the component feed unit but also on the user side of the component feed unit.

According to the thirteenth aspect of the present invention, there can be provided a component mounting device in which the component feed section is equipped with a plurality of the component feed units so that the respective component pickup positions are arrayed in a line, the component feed can be carried out stably with high accuracy by making it possible to pick up the components from the plurality of component pickup positions by means of the plurality of component holding members while the control section in each of the component feed units corrects the amount of displacement between the component pickup positions on the basis of the displacement amount data.

According to the fourteenth aspect of the present invention, by controlling the rotational driving amount of the feed rotor so that the components stored in the component-feeding member are successively positioned in the component pickup position on the basis of the correctional driving amount data of the rotational driving amount of the feed rotor formed based on the displacement amount data of the formation position of each of the feed claws with respect to the rotational direction or the center of rotation of the feed rotor that conveys the component-feeding member, the displacement of each of the feed claws occurring in the process of forming the feed claws or the process of assembling the component feed unit can be corrected in a control manner. Therefore, the mechanically occurring displacement can be corrected in a control manner to allow the mechanical displacement to be eliminated in a pseudo manner. Therefore, the components in the component-feeding member can be conveyed to the component pickup position stably with high accuracy, and stable component feed can be achieved.

According to the fifteenth aspect of the present invention, the control of the rotational driving amount of the feed rotor is carried out so that the actual rotational driving amount calculated on the basis of the position in the detected rotational direction coincides with the rotational driving amount based on the correctional driving amount data while directly detecting the position in the rotational direction of the feed rotor. By this operation, the above-mentioned position can be detected more accurately than when the position of the feed rotor is indirectly detected via a drive transmission device or the like. Therefore, high-accuracy stable component feed can be achieved.

According to the sixteenth aspect of the present invention, the displacement amount data is the data formed by capturing the image of the rotational movement position of each of the feed claws in the rotational direction of the feed rotor when the feed rotor is rotationally driven so that each of the components is positioned in the component pickup position on the basis of the rotational movement position of each of the feed claws detected based on the image and the position where each of the feed claws should be positioned. With this arrangement, the amount of displacement of each of the feed claws is securely corrected by the correctional driving amount data formed based on the displacement amount data, and high-accuracy stable conveyance of the component-feeding member can be achieved.

According to the seventeenth aspect of the present invention, even if the displacement amount data is the rotational angle displacement amount data of each of the feed claws, the effects of the aforementioned aspects can be obtained.

According to the eighteenth aspect of the present invention, by correcting the rotational driving amount data of each of the feed claws of the feed rotor that conveys the component-feeding member so that each of the components is positioned in the component pickup position on the basis of the displacement amount data, the correctional driving amount data of the feed rotor is formed and the rotational driving amount of the feed rotor is controlled by the formed correctional driving amount data. By this operation, the amount of displacement can be reliably corrected, and high-accuracy stable component feed can be achieved.

According to the nineteenth aspect or the twentieth aspect of the present invention, the amount of displacement can also be detected by capturing the image of the component positioned in the component pickup position by means of the board recognition device provided for the component mounting apparatus. Moreover, the amount of displacement, which is the detected distance dimension, can also be converted into the rotational driving amount, which is the rotational angle, of the feed rotor. Therefore, even if the board recognition device is employed as described above, the amount of displacement can reliably be detected, and the correction can be achieved.

It is to be understood that proper combination of arbitrary embodiments among the above-described various embodiments may offer the effects included in respective embodiment.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A component feed unit (10) for positioning storage sections (3), which releasably store a plurality of electronic components (4) in a belt-shaped component-feeding member (1) in which the storage sections and feed perforations (2) are formed at regular intervals (P) in a lengthwise direction thereof, in a component pickup position (16) and allowing the components to be fed from the positioned storage section, the unit comprising:
a feed rotor (6) which has its outer periphery provided with a plurality of feed claws (5) capable of being engaged with the feed perforations, for conveying the component-feeding member in its rotational direction by rotating around its center of rotation (R);
a rotary driving device (7) for rotationally driving the feed rotor so that the component-feeding member is conveyed; and
a control section (8) for controlling rotational driving amount of the feed rotor by the rotary driving device,
the control section retains correctional driving amount data of the rotational driving amount of the feed rotor formed based on displacement amount data of a formation position of the feed claws with respect to the rotational direction or the center of rotation of the feed rotor and controls the rotational driving amount of the feed rotor based on the correctional driving amount data so that the components are successively positioned in the component pickup position.

2. The component feed unit as claimed in claim 1, wherein the displacement amount data are data formed based on an actual rotational movement position of each of the feed claws in the rotational direction of the feed rotor and a position where each of the feed claws should be positioned, when the feed rotor is rotationally driven by the rotary driving device so that each of the components is positioned in the component pickup position.

3. The component feed unit as claimed in claim 1, wherein the control section comprises:
a correctional driving amount data formation section (21) for forming the correctional driving amount data of the feed rotor by correcting the rotational driving amount data of each of the feed claws of the feed rotor by the rotary driving device capable of positioning each of the components in the component pickup position based on the displacement amount data; and
a data retainment section (22) for retrievably retaining the displacement amount data, the rotational driving amount data and the correctional driving amount data.

4. The component feed unit as claimed in claim 1, wherein the amount of displacement is an amount of displacement (D) of the actual formation position with respect to a reference position of each of the feed claws that should be formed on the outer periphery of the feed rotor in correspondence with the regular formation intervals of the feed perforations of the component-feeding member.

5. The component feed unit as claimed in claim 1, wherein the control section is operable to detect the rotational position of the feed rotor and controls the rotational driving amount of the feed rotor by the rotary driving device while carrying out the detection.

6. The component feed unit as claimed in claim 5, wherein the detection of the rotational position of the feed rotor is carried out by an encoder (9) for directly detecting the position in the rotational direction of the feed rotor.

7. The component feed unit as claimed in claim 5, wherein the detection of the rotational position of the feed rotor is carried out by a detection device (90) including an object (91) to be detected provided for the feed rotor and a detection section (92) for detecting a movement position of the object to be detected by the rotational driving of the feed rotor.

8. The component feed unit as claimed in claim 1, wherein each of the feed claws has a cross section formed into a roughly circular shape perpendicularly to a radial direction of the feed rotor, and the component-feeding member is conveyed while making the roughly circular peripheral surfaces abut against inner peripheral surfaces of. the feed perforations formed in a roughly circular shape at the component-feeding member.

9. The component feed/unit as claimed in claim 1, wherein the rotary driving device has a rotary driving motor (7) which is connected directly to the feed rotor for directly rotationally driving the feed rotor.

10. The component feed unit as claimed in claim 1, wherein the feed rotor has a rotational reference position in its rotational direction, and the control section is operable to correct the rotational reference position in the rotational direction based on the correctional driving amount data.

11. A component feed device comprising:
a unit retainment section (74a) removably equipped with the component feed unit claimed in any one of claims 1 through 10;
a reel retainment portion (71) which is provided for the unit retainment section for rotatably removably retaining a component feed reel (72) around which the component-feeding member is wound and stored; and
a conveyance passage (73) for conveying the component-feeding member fed by being unwinded from the component feed reel retained by the reel retainment portion feedably to the component feed unit.

12. A feed claw displacement amount measurement device comprising:
a retainment base (47a) which releasably retains the component feed unit claimed in any one of claims 1 through 10;
an imaging device (41) which is fixed to the retainment base for capturing an image of the formation position of each of the feed claws with respect to the center of rotation or the rotational direction of the feed rotor in the retained component feed device;
a displacement amount data formation section (42) for forming displacement amount data of the formation position of each of the feed claws based on each of the images captured by the imaging device; and
a data output section (42) for outputting the formed displacement amount data to the control section of the component feed device.

13. A component mounting apparatus comprising:
a component feed section (37) removably provided with a plurality of the component feed units claimed in any one of claims 1 through 10 arrayed in a line so that the respective component pickup positions are arrayed in a line;
a head section (35, 60) which is provided with a plurality of component holding members (31, 61) for releasably holding the components and are arrayed in a line along a direction in which the component pickup positions are arranged, holds the components fed from one or the plurality of component pickup positions among the plurality of component pickup positions by means of the component holding members and mounts the held one or the plurality of components in mounting position or positions of a board (32);
a board holding section (38) which releasably holds the board; and
a positioning device (33) for carrying out positioning of the held board and the component holding members,
the control section of each of the component feed units corrects the amount of displacement between the component pickup positions based on the displacement amount data, and allows the components to be picked up from the plurality of component pickup positions by the plurality of component holding members.

14. A component feed method for conveying a belt-shaped component-feeding member (1), in which component storage sections (3) that store a plurality of electronic components (4) while allowing the components to be picked up and feed perforations (2) are formed at regular intervals (P) in a lengthwise direction thereof, in its rotational direction by the rotation around a center of rotation (R) of a feed rotor (6) on an outer periphery of which a plurality of feed claws (5) capable of being engaged with the feed perforations and positioning each of the storage sections in a component pickup position (16) to feed the component from the positioned storage section, whereby
the rotational driving amount of the feed rotor is controlled based on correctional driving amount data of the rotational driving of the feed rotor formed based on displacement amount data of each of the feed claws with respect to the center of rotation or the rotational direction of the feed rotor, and the components are positioned successively in the component pickup position to feed the components.

15. The component feed method as claimed in claim 14, wherein the control of the rotational driving amount of the feed rotor is carried out so that an actual rotational driving amount calculated based on the position in the detected rotational direction coincides with a rotational driving amount based on the correctional driving amount data while directly detecting the position in the rotational direction of the feed rotor.

16. The component feed method as claimed in claim 14, wherein the displacement amount data of the formation position of each of the feed claws is formed by capturing an image of a rotational movement position of each of the feed claws in the rotational direction when the feed rotor is rotationally driven so that each of the components is positioned in the component pickup position and being based on the rotational movement position of each of the feed claws detected based on each of the image and the position where each of 'the feed claws should be positioned.

17. The component feed method as claimed in claim 14, wherein the displacement amount data are data of the amount of displacement of the rotational angle of each of the feed claws.

18. A component feed method as claimed in claim 14, wherein the rotational driving amount data of each of the feed claws of the feed rotor that conveys the component-feeding member so that each of the components is positioned in the component pickup position is corrected based on the displacement amount data, whereby the correctional driving amount data of the feed rotor is formed and the rotational driving amount of the feed rotor is controlled by the formed correctional driving amount data.

19. The component feed method as claimed in claim 14, wherein capturing an image of the component positioned in the component pickup position by a board recognition device (34, 62) provided for a component mounting apparatus (101) that mounts the component fed to the component pickup position onto the board,
calculating an amount of displacement between the positioned component and the component pickup position based on the captured image, and
forming correctional driving amount data of the rotational driving amount of the feed rotor based on the calculated amount of displacement.

20. The component feed method as claimed in claim 19, wherein the amount of displacement between the positioned component and the component pickup position is a distance dimension in a direction in which the component-feeding member is conveyed, and the correctional driving amount data of the rotational driving amount of the feed rotor, which is a rotational angle, is formed based on the distance dimension and a diameter of the feed rotor.
